(19) Europäisches Patentamt
European Patent Office
Office européen des brevets

(11) **EP 4 027 357 A1**

(12) **EUROPÄISCHE PATENTANMELDUNG**

(43) Veröffentlichungstag:
**13.07.2022 Patentblatt 2022/28**

(21) Anmeldenummer: **21215546.9**

(22) Anmeldetag: **17.12.2021**

(51) Internationale Patentklassifikation (IPC):
*H01F 1/18* (2006.01)    *C21D 1/26* (2006.01)
*C21D 8/12* (2006.01)    *C22C 19/07* (2006.01)
*C22C 38/12* (2006.01)

(52) Gemeinsame Patentklassifikation (CPC):
**H01F 1/18; C21D 1/26; C21D 8/1222;
C21D 8/1233; C22C 1/02; C22C 19/07;
C22C 30/00; C22C 38/12**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(30) Priorität: **18.12.2020 DE 102020134294**

(71) Anmelder: **Vacuumschmelze GmbH & Co. KG
63450 Hanau (DE)**

(72) Erfinder:
• **VOLBERS, Niklas
63450 Hanau (DE)**
• **FOHR, Jan Frederik
63450 Hanau (DE)**
• **MÜLLER, Michael
63450 Hanau (DE)**

(74) Vertreter: **JENSEN & SON
366-368 Old Street
London EC1V 9LT (GB)**

(54) **FECOV-LEGIERUNG UND VERFAHREN ZUM HERSTELLEN EINES BANDS AUS EINER FECOV-LEGIERUNG**

(57) In einem Ausführungsbeispiel ist eine Fe-CoV-Legierung mit der Zusammensetzung bereitgestellt, die im Wesentlichen aus 30 Gew. % ≤ Co ≤ 55 Gew. %, 0,4 Gew. % ≤ V ≤ 1,5 Gew. %, 0,04 Gew. % ≤ Nb ≤ 0,10 Gew. %, 0,0 Gew. % ≤ Ta ≤ 0,20 Gew. %, 0,04 Gew. % ≤ Nb + 0,5·Ta ≤ 0,15 Gew. %, max. 0,02 Gew. % C, 0,0 Gew. % ≤ Si ≤ 0,50 Gew. %, 0,0 Gew. % ≤ Al ≤ 0,50 Gew. %, max. 0,5 Gew. % Mn, max. 0,5 Gew. % Cr, max. 0,5 Gew. % Ni, max. 0,5 Gew. % W, max. 0,5 Gew. % Mo, max. 0,5 Gew. % Zr, Rest Fe, sowie bis zu 1 Gew. % weitere Verunreinigungen besteht, und die einen Phasenübergang von einem ferritischen $\alpha$ Phasengebiet in ein ferritisch/austenitisches $\alpha+\gamma$ Mischgebiet aufweist, der bei einer Übergangstemperatur $T(\alpha/\alpha+\gamma)$ stattfindet, wobei $T(\alpha/\alpha+\gamma) \geq 900°C$, vorzugsweise ≥ 920°C, vorzugsweise ≥ 940°C.

Fig. 1

**EP 4 027 357 A1**

**Beschreibung**

Der aktuelle Trend zur Elektrifizierung führt zu einem steigenden Bedarf an elektrischen Maschinen mit hoher Leistungsdichte und gleichzeitig hoher Effizienz. Eine Komponente zur Verbesserung dieser Eigenschaften ist das im Stator und ggf. auch im Rotor der elektrischen Maschine verwendete weichmagnetische Material, das die Aufgabe hat, den magnetischen Fluss zu führen.

Typischerweise kommen hier dünne Bleche aus Eisen-Silizium-Legierungen (FeSi) mit einem Si-Gehalt von 2 bis 4 Gew. % zum Einsatz, da diese ein für die meisten Anwendungen ausreichendes Eigenschaftsprofil aufweisen und zudem kommerziell sehr gut verfügbar sind. Für sehr anspruchsvolle elektrische Maschinen mit höchsten Anforderungen, wie sie z.B. im Bereich des Rennsports oder der Luftfahrt gestellt werden, reichen diese Materialien aber nicht in allen Fällen aus, um die Vorgaben an Leistungsdichte und ggf. auch an die Effizienz zu erfüllen.

In der Luftfahrt werden für Generatoren zur Stromerzeugung schon seit vielen Jahrzehnten Materialien aus Eisen-Kobalt-Vanadium (FeCoV) verwendet, da bei diesen durch den Zusatz an Kobalt die Sättigungspolarisation erhöht wird. Diese auch als V-Permendur bezeichneten Legierungen mit der Grundzusammensetzung 49% Fe 49% Co und 2% V weisen eine Sättigungspolarisation Js von bis zu 2,30 T auf, was deutlich oberhalb des Werts von etwa 2 T bei FeSi-basierten Legierungen liegt. Somit ist es in der Praxis möglich, mit FeCoV bei gleichem Volumen Elektromotoren mit einer 20 bis 50% höheren Leistung zu bauen.

Weiterhin ergibt sich auf Grund der niedrigen Kristallanisotropie K1 des FeCoV-Materials eine sehr geringe Koerzitivfeldstärke Hc, die typischerweise im Bereich von unter 100 A/m (=1 A/cm) liegt. In Kombination mit einem elektrischen Widerstand von etwa 0,4 $\mu\Omega$m (=40 $\mu\Omega$cm), was ungefähr dem Wert typischer FeSi-Legierungen entspricht, ergeben sich daher sehr niedrige Ummagnetisierungsverluste $P_{Fe}$. Die Effizienz von elektrischen Maschinen mit V-Permendur als Statormaterial ist daher sehr hoch.

Die ohnehin sehr hohen Anforderungen an Elektromotoren steigen aktuell aber weiter an, insbesondere durch neue Anwendungen im Bereich des elektrischen Fliegens. Unter Verwendung von FeCoV-Werkstoffen können aktuell bereits Motoren mit einem Leistungsgewicht von 5 kW/kg gebaut werden, die langfristigen Ziele liegen aber bei bis zu 20 kW/kg. Um dem gerecht zu werden, bedarf es u.a. auch einer weiteren Verbesserung des weichmagnetischen Materials hinsichtlich der Leistungsdichte und der Effizienz.

Die wichtigste Kenngröße zur Erzielung einer großen Leistungsdichte ist dabei die Sättigungspolarisation Js als Maß für die maximal mögliche Magnetisierung des Materials. Für die Praxis relevant sind aber insbesondere auch die Induktionen B(H) bei Feldstärken H zwischen 100 A/m (=1 A/cm) und 20 kA/m (=200 A/cm), da dies dem Aussteuerungsbereich entspricht, den der Großteil des Materials in der Praxis erfährt.

Für eine hohe Effizienz wiederum ist es von Bedeutung, die zum Ummagnetisieren notwendige Energie gering zu halten. Diese auch als Ummagnetisierungsverluste $P_{Fe}$ bezeichnete Kenngröße setzt sich aus den Hystereseverlusten, den Wirbelstromverlusten und den anomalen Verlusten zusammen. Zur Einstellung niedriger Hystereseverluste sollte die Koerzitivfeldstärke Hc möglichst klein sein. Eine Reduktion der Wirbelstromverluste gelingt durch einen hohen spezifischen elektrischen Widerstand $\rho_{el}$ und eine geringe Blechdicke d. Die anomalen Verluste sind durch die Domänenstruktur bestimmt und lassen sich über Korngröße und Zusammensetzung beeinflussen. Im System FeCoV mit ungefähr gleichen Anteilen an Fe und Co sind die anomalen Verluste relativ gering, so dass zur Verringerung der Ummagnetisierungsverluste im Wesentlichen die Hysterese- und Wirbelstromverluste minimiert werden müssen.

Bei der Optimierung einer FeCo-Zusammensetzung sollten beide Aspekte berücksichtigt werden, d.h. ein verbessertes Material muss sowohl eine hohe Sättigungspolarisation und hohe Permeabilität aufweisen, als auch niedrige Gesamtverluste durch geringe Hysterese- und Wirbelstromanteile.

Die Aufgabe besteht somit darin, eine FeCoV-Legierung bereitzustellen, die eine hohe Sättigungspolarisation, eine hohe Permeabilität und niedrige Gesamtverluste aufweist, die sich auch großtechnisch herstellen lässt.

Erfindungsgemäß wird eine FeCoV-Legierung mit der Zusammensetzung bereitgestellt, die im Wesentlichen aus

30 Gew. % $\leq$ Co $\leq$ 55 Gew. %, vorzugsweise 45 Gew. % $\leq$ Co $\leq$ 55 Gew. %,

0,4 Gew. % $\leq$ V $\leq$ 1,5 Gew. %, vorzugsweise 0,6 Gew. % $\leq$ V $\leq$ 1,35 Gew. %, vorzugsweise 0,8 Gew. % $\leq$ V $\leq$ 1,2 Gew. %,

0,0 Gew. % $\leq$ Nb $\leq$ 0,15 Gew. %, vorzugsweise 0,0 Gew. % $\leq$ Nb $\leq$ 0,10 Gew. %, vorzugsweise 0,04 Gew. % $\leq$ Nb $\leq$ 0,10 Gew. %,

0,0 Gew. % $\leq$ Ta $\leq$ 0,30 Gew. %, vorzugsweise 0,0 Gew. % $\leq$ Ta $\leq$ 0,20 Gew. %, vorzugsweise 0,0 Gew. % $\leq$ Ta $\leq$ 0,15 Gew. %,

0,0 Gew. % $\leq$ Nb + 0,5·Ta $\leq$ 0,3 Gew. %, vorzugsweise 0,0 Gew. % $\leq$ Nb + 0,5·Ta $\leq$ 0,2 Gew. %, vorzugsweise 0,04 Gew. % $\leq$ Nb + 0,5·Ta $\leq$ 0,15 Gew. %, vorzugsweise 0,04 Gew. % $\leq$ Nb + 0,5·Ta $\leq$ 0,10 Gew. %,

max. 0,02 Gew. % C, vorzugsweise max. 0,01 Gew. %, vorzugsweise max. 0,005 Gew. %,

0,0 Gew. % $\leq$ Si $\leq$ 0,50 Gew. %, vorzugsweise 0,0 Gew. % $\leq$ Si $\leq$ 0,30 Gew. %, 0,0 Gew. % $\leq$ Al $\leq$ 0,50 Gew. %,

vorzugsweise 0,0 Gew. % $\leq$ Al $\leq$ 0,30 Gew. %,
max. 0,5 Gew. % Mn, max. 0,5 Gew. % Cr, max. 0,5 Gew. % Ni, max. 0,5 Gew. % W, max. 0,5 Gew. % Mo, max. 0,5 Gew. % Zr,
Rest Fe, sowie bis zu 1 Gew. % weitere Verunreinigungen besteht.

Die Verunreinigungen können eine oder mehrere Elemente der Gruppe O, N, S, P, Ce, Ti, Mg und Be enthalten.

Die FeCoV-Legierung weist einen Phasenübergang von einem ferritischen $\alpha$ Phasengebiet in ein ferritisch/austenitisches $\alpha+\gamma$ Mischgebiet auf, der bei einer Übergangstemperatur $T(\alpha/\alpha+\gamma)$ stattfindet, wobei $T(\alpha/\alpha+\gamma) \geq 900°C$, vorzugweise $\geq 905°C$, vorzugsweise $\geq 910°C$ vorzugsweise $\geq 920°C$, vorzugsweise $\geq 940°C$.

Bei aufsteigender Temperatur findet der Phasenübergang zwischen dem ferritischen $\alpha$ Phasengebiet und dem ferritisch/austenitischen $\alpha+\gamma$ Mischgebiet bei einer ersten Übergangstemperatur $T_{\alpha/\alpha+\gamma}$ und bei weiter ansteigender Temperatur der Übergang zwischen dem ferritisch/austenitischen $\alpha+\gamma$ Mischgebiet und dem austenitischen $\gamma$ Phasengebiet bei einer zweiten Übergangstemperatur $T_{\alpha+\gamma/\gamma}$ statt.

Die erfindungsgemäße FeCoV-Legierung und der zugehörige Fertigungsweg ermöglichen es, weichmagnetische Bleche herzustellen, die hinsichtlich der weichmagnetischen Eigenschaften mehrere vorteilhafte Merkmale gegenüber den bisher bekannten FeCo-2V Legierungen aufweisen:

Hohe Sättigungspolarisation, um bei hohen Feldstärken maximale Flussdichten zu erzielen.
Sehr hohe Maximalpermeabilität, wodurch schon bei geringen äußeren Feldstärken H hohe Flussdichten B(H) möglich sind.
Sehr niedrige Koerzitivfeldstärke, wodurch eine Absenkung der Hystereseverluste möglich wird.
Geringe Wirbelstromverluste, wodurch in Kombination mit den geringen Hystereseverlusten die gesamten Ummagnetisierungsverluste niedrig gehalten werden können.

Die Kombination dieser Eigenschaften ermöglicht es, Blechpakete zum Einsatz in elektrischen Motoren und Generatoren herzustellen, die über einen weiten Feldstärkebereich hohe Induktionen aufweisen und damit eine extrem hohe Leistungsdichte aufweisen. Durch die hohe Sättigung lässt sich ein besonders hohes maximales Drehmoment erzeugen. Gleichzeitig ermöglichen die niedrigen Ummagnetisierungsverluste eine sehr gute Effizienz.

Diese Eigenschaften können erreicht werden, in dem die maximale Temperatur der Schlussglühung erhöht wird, und beispielweise bei oberhalb 900°C, vorzugsweise oberhalb 905°C, vorzugsweise oberhalb 910°C, vorzugsweise oberhalb 920°C oder vorzugsweise oberhalb 940°C liegt. Der Legierung in seiner Enddicke wird die Schlussglühung unterzogen.

Im System FeCoV bei Co-Gehalten über 30 Gew.-% wird jedoch die maximal mögliche Schlussglühtemperatur durch den Phasenübergang $\alpha/\alpha+\gamma$ beschränkt. Nur durch eine Glühung im ferritischen $\alpha$-Bereich können die guten weichmagnetischen Eigenschaften eingestellt werden. Wird der Phasenübergang während der Wärmebehandlung überschritten, so kommt es zu einer dauerhaften Schädigung der magnetischen Eigenschaften, was sich z.B. in einem starken Anstieg der Koerzitivfeldstärke und einem Absinken der Maximalpermeabilität deutlich macht.

Durch ein Anheben des Phasengrenzlinie $T(\alpha/\alpha+\gamma)$ kann die im ferritischen $\alpha$-Gebiet stattfindende magnetische Schlussglühung bei höheren Temperaturen erfolgen.

Erfindungsgemäß erfolgt die Anhebung des Phasenübergangs durch eine Absenkung des V-Gehalts auf 0,4 Gew. % bis 1,50 Gew. %. Es wurde gefunden, dass eine Verringerung des V-Gehalts um 0,1 Gew. % ein Anheben des Phasenübergangs $T(\alpha/\alpha+\gamma)$ um 4,5°C zur Folge hat. Die Temperatur Tmax, bei der die magnetische Schlussglühung stattfindet, kann in gleichem Maße erhöht werden. Der V-Gehalt kann weiter auf unter 1, 35 Gew. % oder auf unter 1,2 Gew. % abgesenkt werden, um den Phasenübergang $T(\alpha/\alpha+\gamma)$ und somit die maximale Temperatur bei der Schlussglühung weiter zu erhöhen und die magnetischen Eigenschaften weiter zu verbessern.

Dadurch ergeben sich hinsichtlich dieser Glühung einige Vorteile. Durch die bei höherer Temperatur gegebene höhere Selbstdiffusion ergibt sich bei gleicher Glühdauer ein stärkeres Kornwachstum, d.h. nach der Schlussglühung liegt eine größere Korngröße dk vor. Gemäß der Beziehung von Mager (Hc $\alpha$ 1/dk) ergibt sich damit eine niedrigere Koerzitivfeldstärke Hc und letztendlich damit auch eine höhere Permeabilität. Die reduzierende Wirkung des Wasserstoffs wird verbessert, d.h. Oxide können besser reduziert und oberflächennahe Verunreinigungen, die ggf. nachteilig für die weichmagnetischen Eigenschaften sein können, verringert werden. Der Effekt dieser Oberflächenverbesserung ist gerade bei dünnen Bändern der Abmessung 0,25 mm oder dünner von besonderer Bedeutung und führt zu einer Verbesserung in den weichmagnetischen Eigenschaften.

Als weiterer positiver Effekt führt eine Absenkung des V-Gehalts zu einer Anhebung der Sättigungspolarisation. Mit V-Gehalten zwischen 0,4 Gew. % und 1,5 Gew. % bzw. 0,6 Gew. % $\leq$ V $\leq$ 1,35 Gew. % und 0,8 Gew. % $\leq$ V $\leq$ 1,2 Gew. % lassen sich Sättigungswerte J160 von über 2,32 T bis zu 2,37 T erzielen, je nach V-Gehalt.

Es wurde festgestellt, dass das Verhältnis von Co zu Fe einen Einfluss auf die Induktion B, insbesondere bei kleineren Werten von H, beispielsweise H=1 A/cm und 3A/cm hat. Das Verhältnis aus Co/Fe kann in den Legierungen neben der Texturbildung vor allem die Ordnung und damit die magnetokristalline Anisotropie und somit die erzielbaren weichmagnetischen Eigenschaften beeinflussen. Es wurde festgestellt, dass die magnetischen Eigenschaften B1 (d.h. B bei H = 1 A/cm) und B3 (d.h. B bei H = 3 A/cm) verbessert werden können, wenn $0,94 \leq Co/Fe \leq 1,01$, vorzugsweise $0,97 \leq Co/Fe \leq 1,005$ gilt, wobei hier das Verhältnis Co/Fe aus den jeweiligen Gew. % an Co und Fe berechnet wird, ohne bei der Berechnung des Verhältnisses die Verunreinigungsgehalte an C, S, N, O zu berücksichtigen.

Bei einem abgesenkten V-Gehalt ergibt sich ein gegenüber VACODUR 49 reduzierter elektrischer Widerstand. Je nach Blechdicke und Anwendungsfall kann es dadurch zu erhöhten Wirbelstromverlusten kommen. Da aber der elektrische Widerstand nur linear in die Wirbelstromverluste eingeht, die Blechdicke aber quadratisch, kann der geringere elektrische Widerstand durch eine Absenkung der Blechdicke überkompensiert werden. Typische Blechdicken für die erfindungsgemäße Legierung liegen im Bereich 0,15 mm.

Ein Niob-Gehalt von bis zu 0,15 Gew. % und insbesondere von 0,04 Gew. % bis 0,1 Gewichtsprozent verbessert die Verarbeitbarkeit der Legierung, insbesondere bei der großtechnischen Herstellung vereinfacht, da die Duktilität erhöht wird, was zu einer Vereinfachung des Warmwalzens und besonders des Kaltwalzens führt.

In manchen Ausführungsbeispielen weist die FeCoV-Legierung eine Polarisation J(16 kA/m) $\geq$ 2,30 T, vorzugsweise $\geq$ 2,32 T, vorzugsweise $\geq$ 2,34 T, und/oder eine Maximalpermeabilität $\mu_{max}$ > 25.000, vorzugsweise $\geq$ 30.000, vorzugsweise $\geq$ 35.000, und/oder eine Koerzitivfeldstärke Hc $\leq$ 30 A/m, vorzugsweise $\leq$ 25 A/m, vorzugsweise $\leq$ 20 A/m und/oder einen elektrischen Widerstand von mindestens 0,15 $\mu\Omega$m auf.

In manchen Ausführungsbeispielen weist die FeCoV-Legierung nach einer Wärmebehandlung bei einer Temperatur Tmax, wobei Tmax $\leq$ T($\alpha/\alpha+\gamma$) und Tmax > 900°C, , vorzugsweise $\geq$ 905°C, vorzugsweise $\geq$ 910°C, vorzugsweise $\geq$ 920°C, vorzugsweise $\geq$ 940°C und die Differenz $\Delta$T zwischen Phasenübergang T($\alpha/\alpha+\gamma$) und Glühtemperatur $T_{max}$ höchstens 20°C, vorzugsweise max. 10°C beträgt, eine Polarisation J(16 kA/m) $\geq$ 2,30 T, vorzugsweise $\geq$ 2,32 T, vorzugsweise $\geq$ 2,34 T, und/oder eine Maximalpermeabilität $\mu_{max}$ > 25.000, vorzugsweise $\geq$ 30.000, vorzugsweise $\geq$ 35.000, und/oder eine Koerzitivfeldstärke Hc $\leq$ 30 A/m, vorzugsweise $\leq$ 25 A/m, vorzugsweise $\leq$ 20 A/m und/oder einen elektrischen Widerstand von mindestens 0,15 $\mu\Omega$m auf.

In manchen Ausführungsbeispielen weist die FeCoV-Legierung eine Polarisation J(16 kA/m) $\geq$ 2,30 T, vorzugsweise $\geq$ 2,32 T, vorzugsweise $\geq$ 2,34 T, und eine Maximalpermeabilität $\mu_{max}$ > 25.000, vorzugsweise $\geq$ 30.000, vorzugsweise $\geq$ 35.000, und eine Koerzitivfeldstärke Hc $\leq$ 30 A/m, vorzugsweise $\leq$ 25 A/m, vorzugsweise $\leq$ 20 A/m und einen elektrischen Widerstand von mindestens 0,15 $\mu\Omega$m auf.

In manchen Ausführungsbeispielen weist die FeCoV-Legierung eine oxidische Beschichtung auf.

In manchen Ausführungsbeispielen weist die FeCoV-Legierung die Gestalt eines Bands, eines Blechs oder eines Teils auf.

Erfindungsgemäß wird auch ein Verfahren zum Herstellen eines Bandes aus einer CoFe-Legierung bereitgestellt, das Folgendes umfasst.

Eine Schmelze bestehend im Wesentlichen aus

30 Gew. % $\leq$ Co $\leq$ 55 Gew. %, vorzugsweise 45 Gew. % $\leq$ Co $\leq$ 55 Gew. %,
0,4 Gew. % $\leq$ V $\leq$ 1,5 Gew. %, vorzugsweise 0,6 Gew. % $\leq$ V $\leq$ 1,35 Gew. %, vorzugsweise 0,8 Gew. % $\leq$ V $\leq$ 1,2 Gew. %,
0,0 Gew. % $\leq$ Nb $\leq$ 0,15 Gew. %, vorzugsweise 0,0 Gew. % $\leq$ Nb $\leq$ 0,10 Gew. %, vorzugsweise 0,04 Gew. % $\leq$ Nb $\leq$ 0,10 Gew. %,
0,0 Gew. % $\leq$ Ta $\leq$ 0,30 Gew. %, vorzugsweise 0,0 Gew. % $\leq$ Ta $\leq$ 0,2 Gew. vorzugsweise 0,0 Gew. % $\leq$ Ta $\leq$ 0,15 Gew. % ,
0,00 Gew. % $\leq$ Nb + 0,5·Ta $\leq$ 0,30 Gew. %, vorzugsweise 0,04 Gew. % $\leq$ Nb + 0,5·Ta $\leq$ 0,15 Gew. %, vorzugsweise 0,04 Gew. % $\leq$ Nb + 0,5·Ta $\leq$ 0,10 Gew. %,
max. 0,02 Gew. % C, vorzugsweise max. 0,01 Gew. %, vorzugsweise max. 0,005 Gew. %,
0,0 Gew. % $\leq$ Si $\leq$ 0,50 Gew. %, vorzugsweise 0,0 Gew. % $\leq$ Si $\leq$ 0,30 Gew. %, 0,0 Gew. % $\leq$ Al $\leq$ 0,50 Gew. %, vorzugsweise 0,0 Gew. % $\leq$ Al $\leq$ 0,30 Gew. %, max. 0,5 Gew. % Mn, max. 0,5 Gew. % Cr, max. 0,5 Gew. % Ni, max. 0,5 Gew. % W, max. 0,5 Gew. % Mo, max. 0,5 Gew. % Zr,
Rest Fe, sowie bis zu 1 Gew. % weitere Verunreinigungen besteht,

wird bereitbestellt, wobei die FeCoV-Legierung einen Phasenübergang von einem ferritischen $\alpha$ Phasengebiet in ein ferritisch/austenitisches $\alpha+\gamma$ Mischgebiet aufweist, der bei einer Übergangstemperatur T($\alpha/\alpha+\gamma$) stattfindet, wobei T($\alpha/\alpha+\gamma$) $\leq$ 900°C, vorzugweise $\geq$ 905°C, vorzugsweise $\geq$ 910°C, vorzugsweise $\geq$ 920°C, vorzugsweise $\geq$ 940°C.

Die Schmelze wird unter Vakuum abgegossen und anschließend erstarrt zu einem Gussblock. Der Gussblock wird zu einer Bramme und anschließend zu einem Warmwalzband mit einer Dicke d$_1$, warmgewalzt gefolgt von einem Abschrecken des Warmwalzbandes von einer Temperatur oberhalb der Temperatur der Ordnungseinstellung T($\alpha'/\alpha$) auf eine Temperatur kleiner 200 °C.

Nach dem Warmwalzen wird herkömmlich die Legierung auf Raumtemperatur abgekühlt. Die Legierung wird danach, beispielsweise in Form eines Coils auf einer Temperatur, die zwischen dem Ordnungs-/Unordnungsübergang $T(\alpha'/\alpha)$ und dem Phasenübergang $T(\alpha/\alpha+\gamma)$ liegt, erwärmt und dann auf einer Temperatur kleiner 200°C abgeschreckt.

Das abgeschreckte Warmwalzband wird zu einem Band mit einer Dicke $d_2$, kaltgewalzt, wobei $d_2 < d_1$, Das Band wird anschießend bei einer Temperatur $T_{max}$ und einer Haltezeit t, wobei Tmax $\leq$ T($\alpha/\alpha+\gamma$) und Tmax > 900°C, vorzugsweise $\geq$ 905°C, vorzugsweise $\geq$ 910°C, vorzugsweise $\geq$ 920°C, vorzugsweise $\geq$ 940°C wärmebehandelt.

Die Wärmebehandlung bei $T_{max}$ wird als Schlussglühung genannt, weil sie an das Band mit seiner Enddicke durchgeführt wird.

Die Verunreinigungen können eine oder mehrere Elemente der Gruppe O, N, S, P, Ce, Ti, Mg und Be enthalten.

Ein V-Gehalt von maximal 1,5 Gew. % oder maximal 1,35 Gew. % oder maximal 1,2 Gew. % ermöglicht eine Schlussglühung im $\alpha$-Phasengebiet bei einer höheren Temperatur, da die Phasenübergangstemperatur $T(\alpha/\alpha+\gamma)$ bei absteigender V-Gehalt erhöht wird.

In manchen Ausführungsbeispielen beträgt die Differenz $\Delta T$ zwischen dem Phasenübergang $T(\alpha/\alpha+\gamma)$ und der Temperatur $T_{max}$ höchstens 20°C, vorzugsweise max. 10°C.

In manchen Ausführungsbeispielen beträgt t mindestens 0,5 h, vorzugsweise mindestens 4 h, vorzugsweise mindestens 10 h.

In manchen Ausführungsbeispielen erfolgt die Abkühlung von $T_{max}$ bis 700°C mit einer Rate A, die maximal bei 1000°C/h liegt.

In manchen Ausführungsbeispielen beträgt $d_2 \leq 0,35$ mm, vorzugsweise $\leq 0,25$ mm, vorzugsweise $\leq 0,15$ mm.

In manchen Ausführungsbeispielen beträgt $d_1 \leq 3,5$ mm, vorzugsweise $d_1 \leq 2,5$ mm, vorzugsweise $d_1 \leq 2$ mm.

Die Legierung kann einen kleinen Niobzusatz, beispielsweise bis zu 0,1 Gew. % oder zwischen 0,04 Gew.% und 0,1 Gew. % aufweisen, um die Duktilität zu erhöhen. Dies verbessert die Kaltwalzbarkeit und ermöglicht es, die Dicke $d_1$ nach dem Warmwalzen und Abschrecken, beispielsweise durch Kaltwalzen auf eine Dicke $d_2$ von weniger als 0,2 mm zu reduzieren.

In manchen Ausführungsbeispielen wird vor der Wärmebehandlung das Band mit einer Beschichtung auf Basis von Mg-Methylat, auf Basis von Zr-Propylat oder auf Basis von Böhmit beschichtet.

In manchen Ausführungsbeispielen weist nach der Wärmebehandlung das Band eine oxidische Schicht auf.

In manchen Ausführungsbeispielen wird nach dem Warmwalzen das Warmwalzband von einer Temperatur $T_1$, die zwischen einem Ordnungs-/Unordnungsübergang $T(\alpha'/\alpha)$ und dem Phasenübergang $T(\alpha/\alpha+\gamma)$ liegt, abgeschreckt, wobei $T(\alpha'/\alpha) \leq T_1 \leq T(\alpha/\alpha+\gamma)$, vorzugsweise $T(\alpha'/\alpha) \leq T_1 \leq 850$°C.

Das Warmwalzband braucht nicht direkt von der Warmwalztemperatur abgeschreckt zu werden, sondern kann auch nach dem Warmwalzen auf Raumtemperatur abgekühlt und erst später beispielsweise in Form eines Coils auf einer Temperatur $T_1$, die zwischen einem Ordnungs-/Unordnungsübergang $T(\alpha'/\alpha)$ und dem Phasenübergang $T(\alpha/\alpha+\gamma)$ liegt, erwärmt und dann von einer Temperatur oberhalb des Ordnungs-/Unordnungsübergangs $T(\alpha'/\alpha)$ abgeschreckt werden, wobei $T(\alpha'/\alpha) \leq T_1 \leq T(\alpha/\alpha+\gamma)$, vorzugsweise $T(\alpha'/\alpha) \leq T_1 \leq 850$°C.

In manchen Ausführungsbeispielen wird zum Abschrecken des Warmwalzbandes das Warmwalzband mit einer Abkühlrate von mindestens 500 K/s von $T_1$ bis 100°C, vorzugsweise mit mindestens 1000 K/s, vorzugsweise 2000 K/s abgeschreckt.

In manchen Ausführungsbeispielen wird das Warmwalzband in einem Eis-Salzwasserbad mit einer Abkühlrate von mindestens 500 K/s von $T_1$ bis 100°C, vorzugsweise mit mindestens 1000 K/s, vorzugsweise 2000 K/s abgeschreckt.

In manchen Ausführungsbeispielen wird vor dem Kaltwalzen das Band auf eine Temperatur $T_2$, angewärmt, wobei 20°C $\leq T_2 \leq$ 300°C, vorzugsweise 30°C $\leq T_2 \leq$ 200°C, vorzugsweise 50°C $\leq T_2 \leq$ 200°C ist.

In manchen Ausführungsbeispielen werden mehrere Kaltwalzschritte durchgeführt und das Band wird zwischen Kaltwalzschritten auf eine Temperatur $T_2$, angewärmt, wobei 20°C $\leq T_2 \leq$ 300°C, vorzugsweise 30°C $\leq T_2 \leq$ 200°C, vorzugsweise 50°C $\leq T_2 \leq$ 200°C ist.

In manchen Ausführungsbeispielen weist das Band nach der Wärmebehandlung eine Polarisation J(16 kA/m) $\geq 2,30$ T, vorzugsweise $\geq 2,32$ T, vorzugsweise $\geq 2,34$ T, und/oder eine Maximalpermeabilität $\mu_{max} > 25.000$, vorzugsweise $\geq 30.000$, vorzugsweise $\geq 35.000$, und/oder eine Koerzitivfeldstärke Hc $\leq 30$ A/m, vorzugsweise $\leq 25$ A/m, vorzugsweise $\leq 20$ A/m und/oder einen elektrischen Widerstand von mindestens 0,15 $\mu\Omega$m auf.

Ausführungsbeispiele und Beispiele werden nun anhand der Zeichnungen näher erläutert.

Figur 1    zeigt einen Graph des Phasenübergangs $\alpha/\alpha+\gamma$ in Abhängigkeit vom V-Gehalt.

Figur 2    zeigt einen Graph der Polarisation J160 = J(16 kA/m) in Abhängigkeit vom V-Gehalt.

Figur 3    zeigt einen Graph des elektrischen Widerstands im geglühten Zustand in Abhängigkeit vom V-Gehalt.

Figur 4    zeigt einen Graph der Ummagnetisierungsverluste $P_{Fe}$/f je Zyklus bei Bmax=2 T in Abhängigkeit von der Frequenz.

Figur 5      zeigt Neukurven der Ausführungsbeispiele G2 und M1 mit jeweils 1% V.

Figur 6      zeigt einen Graph der Induktion B1 =B(1 A/cm) in Abhängigkeit des Co/Fe-Verhältnisses wobei das Verhältnis Co/Fe dabei aus den Gew. % berechnet wird, ohne bei der Berechnung des Verhältnisses die Verunreinigungsgehalte an C, S, N, O zu berücksichtigen.

Figur 7      zeigt einen Graph der Induktion B3=B(3 A/cm) in Abhängigkeit des Co/Fe-Verhältnisses, wobei das Verhältnis Co/Fe dabei aus den Gew. % berechnet wird, ohne bei der Berechnung des Verhältnisses die Verunreinigungsgehalte an C, S, N, O zu berücksichtigen.

Figur 8      zeigt einen Graph Induktion B8=B(8 A/cm) in Abhängigkeit des Co/Fe-Verhältnisses, wobei das Verhältnis Co/Fe dabei aus den Gew. % berechnet wird, ohne bei der Berechnung des Verhältnisses die Verunreinigungsgehalte an C, S, N, O zu berücksichtigen.

In einem Ausführungsbeispiel ist eine FeCoV-Legierung mit der Zusammensetzung bereitgestellt, die im Wesentlichen aus 30 Gew. % ≤ Co ≤ 55 Gew. %, 0,4 Gew. % ≤ V ≤ 1,5 Gew. %, 0,0 Gew. % ≤ Nb ≤ 0,15 Gew. %, 0,0 Gew. % ≤ Ta ≤ 0,30 Gew. %, 0,00 Gew. % ≤ Nb + 0,5·Ta ≤ 0,30 Gew. %, max. 0,02% C, 0,0 Gew. % ≤ Si ≤ 0,50 Gew. %, 0,0 Gew. % ≤ Al ≤ 0,50 Gew. %, max. 0,5% Mn, max. 0,5% Cr, max. 0,5% Ni, max. 0,5% W, max. 0,5% Mo, max. 0,5% Zr, Rest Fe, sowie bis zu 1 Gew. % weitere Verunreinigungen besteht.

Die FeCoV Legierung weist einen Phasenübergang von einem ferritischen $\alpha$ Phasengebiet in ein ferritisch/austenitisches $\alpha+\gamma$ Mischgebiet zu einem austenitischen $\gamma$ Phasengebiet. Bei aufsteigender Temperatur findet der Phasenübergang zwischen dem ferritischen $\alpha$ Phasengebiet und dem ferritisch/austenitischen $\alpha+\gamma$ Mischgebiet bei einer ersten Übergangstemperatur $T_{\alpha/\alpha+\gamma}$ und bei weiter ansteigender Temperatur der Übergang zwischen dem ferritisch/austenitischen $\alpha+\gamma$ Mischgebiet und dem austenitischen $\gamma$ Phasengebiet bei einer zweiten Übergangstemperatur $T_{\alpha+\gamma/\gamma}$ statt.

Erfindungsgemäß wird die Zusammensetzung so ausgewählt, dass die erste Übergangstemperatur erhöht wird, so dass $T(\alpha/\alpha+\gamma) \geq 900°C$, vorzugweise ≥ 905°C, vorzugsweise ≥ 910°C, vorzugsweise ≥ 920°C, vorzugsweise ≥ 940°C ist.

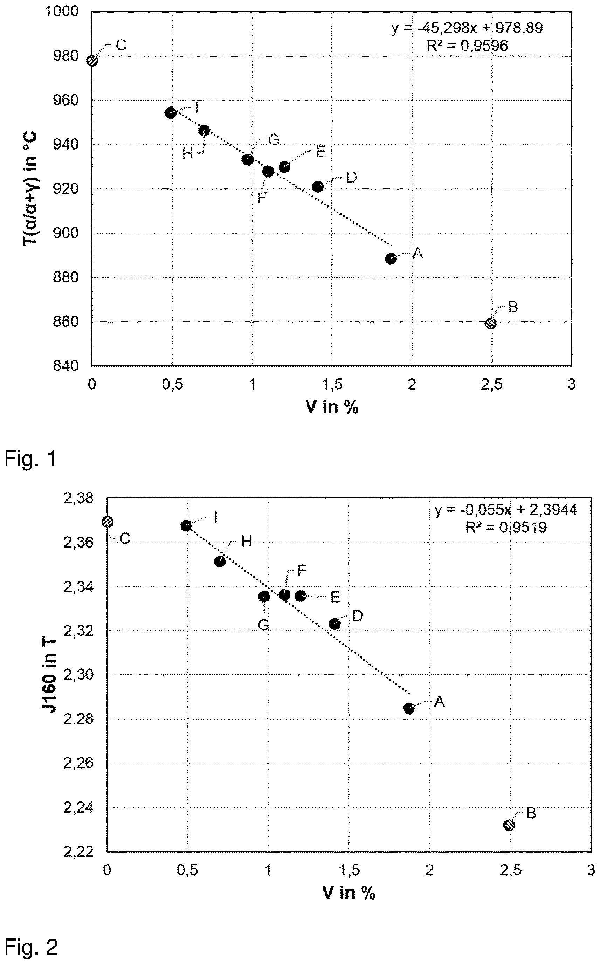

Die Anhebung des Phasenübergangs erfolgt durch eine Absenkung des V-Gehalts auf 0,4 Gew. % bis 1,50 Gew. %. Figur 1 zeigt auf, dass eine Verringerung des V-Gehalts um 0,1 Gew. % ein Anheben des Phasenübergangs $T(\alpha/\alpha+\gamma)$ um 4,5°C zur Folge hat. Die Temperatur $T_{max}$, bei der die magnetische Schlussglühung stattfindet, kann in gleichem Maße erhöht werden.

Dadurch ergeben sich hinsichtlich der Glühung die Vorteile, dass sich durch die bei höherer Temperatur gegebene höhere Selbstdiffusion bei gleicher Glühdauer ein stärkeres Kornwachstum ergibt. Nach der Schlussglühung liegt somit eine größere Korngröße $d_k$ vor. Gemäß der Beziehung von Mager (Hc $\alpha$ $1/d_k$) ergibt sich damit eine niedrigere Koerzitivfeldstärke Hc und letztendlich damit auch eine höhere Permeabilität. Ferner wird die reduzierende Wirkung des Wasserstoffs verbessert. Oxide können somit besser reduziert und oberflächennahe Verunreinigungen, die ggf. nachteilig für die weichmagnetischen Eigenschaften sein können, verringert werden.

Der Effekt dieser Oberflächenverbesserung ist gerade bei dünnen Bändern der Abmessung 0,25 mm oder dünner von besonderer Bedeutung und führt zu einer Verbesserung in den weichmagnetischen Eigenschaften.

Als weiterer positiver Effekt führt eine Absenkung des V-Gehalts zu einer Anhebung der Sättigungspolarisation, vgl. Figur 2. Mit V-Gehalten zwischen 0,4 Gew. % und 1,5 Gew. % lassen sich Sättigungswerte J160 von bis zu 2,37 T erzielen.

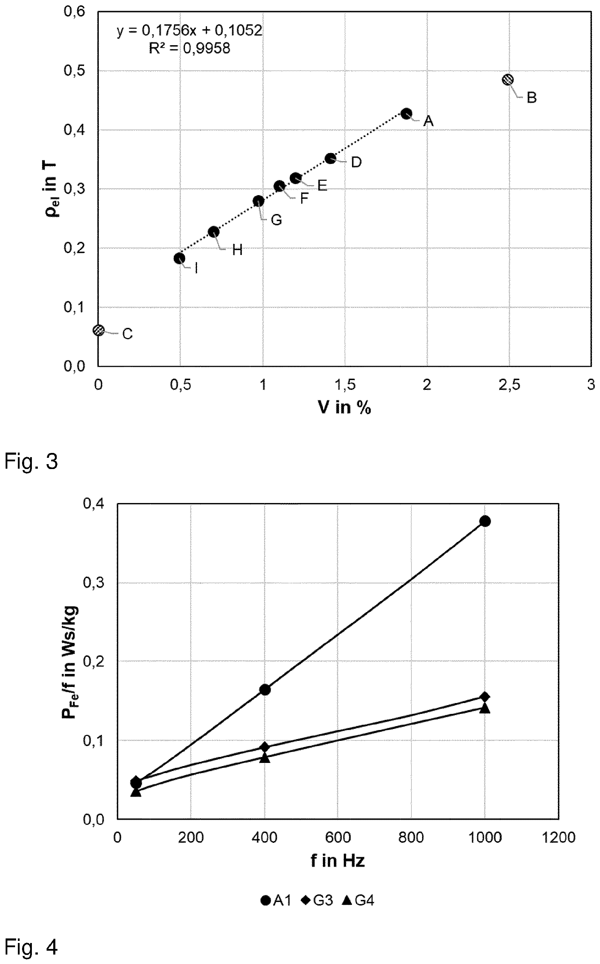

Bei einem abgesenkten V-Gehalt ergibt sich ein gegenüber VACODUR 49 reduzierter elektrischer Widerstand, vgl. Figur 3. Je nach Blechdicke und Anwendungsfall kann es dadurch zu erhöhten Wirbelstromverlusten kommen. Da aber der elektrische Widerstand nur linear in die Wirbelstromverluste eingeht, die Blechdicke aber quadratisch, kann der geringere elektrische Widerstand durch eine Absenkung der Blechdicke überkompensiert werden. Typische Blechdicken für die erfindungsgemäße Legierung liegen im Bereich 0,15 mm.

Die Legierung wird typischerweise als Vorprodukt in Gestalt eines Bandes, Blechs oder Teils bereitgestellt, das wärmebehandelt wird. Diese Wärmbehandlung kann als Schlussglühung bezeichnet werden, da sie möglichst spät im Fertigungsprozess durchgeführt wird, vorzugsweise nach dem letzten Verformungsschritt.

In weiteren Ausführungsbeispielen ist die Zusammensetzung der FeCoV-Legierung näher definiert. Die FeCoV-Legierung kann eine Zusammensetzung bestehend im Wesentlichen aus

30 Gew. % ≤ Co ≤ 55 Gew. %, vorzugsweise 45 Gew. % ≤ Co ≤ 55 Gew. %

0,4 Gew. % ≤ V ≤ 1,5 Gew. %, vorzugsweise 0,6 Gew. % ≤ V ≤ 1,35 Gew. %, vorzugsweise du 0,8 Gew. % ≤ V ≤ 1,2 Gew. %

0,0 Gew. % ≤ Nb ≤ 0,15 Gew. %, vorzugsweise 0,0 Gew. % < Nb ≤ 0,10 Gew. %, vorzugsweise 0,04 Gew. % ≤ Nb ≤ 0,10 Gew. %

0,0 Gew. % ≤ Ta ≤ 0,30 Gew. %, vorzugsweise 0,0 Gew. % ≤ Ta ≤ 0,2 Gew. vorzugsweise 0,0 Gew. % ≤ Ta ≤ 0,15 Gew. %

0,00 Gew. % ≤ Nb + 0,5·Ta ≤ 0,30 Gew. %, vorzugsweise 0,04 Gew. % ≤ Nb + 0,5·Ta ≤ 0,15 Gew. %, vorzugsweise 0,04 Gew. % ≤ Nb + 0,5·Ta ≤ 0,10 Gew. %

max. 0,02 Gew. % C, vorzugsweise max. 0,01 Gew. %, vorzugsweise max. 0,005 Gew. %

0,0 Gew. % ≤ Si ≤ 0,50 Gew. %, vorzugsweise 0,0 Gew. % ≤ Si ≤ 0,30 Gew. % 0,0 Gew. % ≤ Al ≤ 0,50 Gew. %, vorzugsweise 0,0 Gew. % ≤ Al ≤ 0,30 Gew. %

max. 0,5 Gew. % Mn, max. 0,5 Gew. % Cr, max. 0,5 Gew. % Ni, max. 0,5 Gew. % W, max. 0,5 Gew. % Mo, max. 0,5 Gew. % Zr,

Rest Fe, sowie bis zu 1 Gew. % weitere Verunreinigungen haben.

Die Verunreinigungen können eine oder mehrere Elemente der Gruppe O, N, S, P, Ce, Ti, Mg und Be enthalten.

Es wurde gefunden, dass die Zusammensetzung (insbesondere der Co, V und Nb-Gehalt), die Übergangstemperatur $T(\alpha/\alpha+\gamma)$ und die Durchführung einer Wärmebehandlung mit der Temperatur $T_{max}$ größer als 900°C einen großen Einfluss auf die verbesserten magnetischen Eigenschaften hat.

Im Vergleich zu den Zusammensetzungen ohne V (d.h. nur mit Nb und/oder Ta) des Stands der Technik weist die erfindungsgemäße Legierung einen elektrischen Widerstand von mindestens 0,15 μΩm nach der Wärmebehandlung auf.

Zur Durchführung der Wärmebehandlung kann eine glühbeständige Beschichtung verwendet werden, die nach der Glühung als oxidische Beschichtung vorliegt, z.B. DL1 auf Basis von Mg-Methylat, HITCOAT auf Basis von Zr-Propylat oder eine Beschichtung auf Basis von Böhmit.

Einige Merkmale des erfindungsgemäßen Fertigungsweges zur Herstellung der erfindungsgemäßen Legierung sind:

- Eine Warmwalzdicke $d_1$, wobei $d_1 \leq 3,5$ mm, vorzugsweise $d_1 \leq 2,5$ mm, vorzugsweise $d_1 \leq 2$ mm,
- Ein Abschrecken von einer Temperatur $T_1$, die zwischen dem Ordnungs-/Unordnungsübergang $T(\alpha'/\alpha)$ und dem Phasenübergang $T(\alpha/\alpha+\gamma)$ liegt, d.h. $T(\alpha'/\alpha) \leq T_1 \leq T(\alpha/\alpha+\gamma)$, vorzugsweise $T_1 \leq 850$°C, wobei das Abschrecken in einem getrennten Prozessschritt durchgeführt werden kann, nachdem das Warmwalzband auf Raumtemperatur abgekühlt und danach auf $T_1$ erwärmt worden ist,
- Ein Abschrecken im Eis-Salzwasserbad mit einer Abkühlrate von mindestens 500 K/s von $T_1$ bis 100°C, vorzugsweise mit mindestens 1000 K/s, 2000 K/s,
- Ein Anwärmen vor dem Walzen auf eine Temperatur $T_2$, wobei $20$°C $\leq T_2 \leq 300$°C, vorzugsweise $30$°C $\leq T_2 \leq 200$°C, vorzugsweise $50$°C $\leq T_2 \leq 200$°C ist.

Die Kombination möglichst aller Punkte ist wichtig zur Erzielung einer guten Kaltverarbeitbarkeit. Die genannte Abkühlrate ergibt sich bei Verwendung eines Eis-Salzwassergemischs.

In Tabelle 1 sind die Zusammensetzungen von neun verschiedenen FeCo-basierten Sonderschmelzen mit der Bezeichnung A bis I angegeben. Die Angaben zur Konzentration der Elemente Co, V, Nb, Mn, sind in Gew. %, die Angaben zu C, S, O und N in Gew. ppm angegeben. Die nicht in der Tabelle angeführten Restverunreinigungen an Ti, Zr, Ta, P, Cu, Mo und Cr lagen jeweils unter 0,01 Gew. %, der Gehalt an Al unter 0,005 Gew. %. Das Verhältnis Co/Fe wurde aus den jeweiligen Gew. % berechnet, ohne bei der Berechnung des Verhältnisses die Verunreinigungsgehalte an C, S, N, O zu berücksichtigen.

Tabelle **1**

|  | R/Erf | Fe | Co % | V % | Nb % | Mn % | C ppm | S ppm | O ppm | N ppm | T (α'/α) °C | T (α/α+γ) °C | $\rho_{el}$ μΩcm | Charge | Co/Fe |
|---|---|---|---|---|---|---|---|---|---|---|---|---|---|---|---|
| A | **R** | Rest | 48,70 | 1,87 | 0,09 | 0,17 | 27 | 10 | 60 | 8 | 717 | 889 | 42,8 | 93/0579 | 0,990 |
| B | **R** | Rest | 48,60 | 2,49 | 0,09 | 0,17 | 40 | 10 | 20 | 7 | 711 | 830 | 48,6 | 93/0578 | 0,999 |
| C | **R** | Rest | 49,00 | 0,0 | 0,30 | <0,01 | 19 | 8 | 65 | 5 | 735 | 978 | 6,1 | 93/0445 | 0,966 |
| D | **Erf** | Rest | 48,65 | 1,41 | 0,10 | 0,21 | <10 | 10 | 20 | 10 | 718 | 921 | 35,2 | 93/0768 | 0,980 |
| E | **Erf** | Rest | 48,55 | 1,20 | 0,10 | 0,21 | 10 | 10 | 10 | <10 | 720 | 930 | 31,8 | 93/0767 | 0,972 |
| F | **Erf** | Rest | 48,95 | 1,10 | 0,10 | 0,21 | <10 | 10 | 90 | 10 | 722 | 928 | 30,6 | 93/0766 | 0,986 |
| G | **Erf** | Rest | 48,55 | 0,97 | 0,10 | 0,17 | 26 | 9 | 48 | 7 | 726 | 933 | 28,0 | 93/0581 | 0,967 |
| H | **Erf** | Rest | 48,55 | 0,70 | 0,10 | 0,18 | 23 | 9 | 55 | 7 | 730 | 946 | 22,8 | 93/0582 | 0,962 |
| I | **Erf** | Rest | 48,50 | 0,49 | 0,08 | 0,17 | 24 | 9 | 61 | 7 | 732 | 954 | 18,4 | 93/0583 | 0,955 |
|  |  |  |  |  |  |  |  |  |  |  |  |  |  |  |  |
| J | **Erf** | Rest | 48,5 | 0,95 | 0,09 | - | 29 | 10 | 40 | 10 | 720 | 945 | 27,2 | 93/0794 | 0,961 |
| K | **R** | Rest | 49,3 | 0,97 | - | 0,06 | 46 | 8 | 63 | 8 | 718 | 940 | 27,0 | 93/0799 | 0,993 |
| L | **Erf** | Rest | 49,3 | 0,99 | 0,06 | 0,06 | 31 | 8 | 76 | 8 | 717 | 935 | 28,0 | 93/0800 | 0,994 |
| M | **Erf** | Rest | 49,3 | 0,99 | 0,09 | 0,06 | 27 | 7 | 89 | 8 | 717 | 937 | 28,4 | 93/0801 | 0,995 |
| N | **Erf** | Rest | 49,2 | 0,97 | 0,09 | 0,37 | 25 | 9 | 85 | 7 | 725 | 923 | 27,9 | 93/0807 | 0,997 |
| O | **Erf** | Rest | 49,1 | 1,2 | 0,05 | 0,22 | 21 | 10 | 59 | 7 | 719 | 921 | 31,9 | 93/0817 | 0,993 |
| P | **Erf** | Rest | 49,2 | 1,4 | 0,05 | 0,21 | 18 | 10 | 48 | 7 | 716 | 915 | 34,7 | 93/0819 | 1,001 |
|  |  |  |  |  |  |  |  |  |  |  |  |  |  |  |  |
| Q | **R** | Rest | 49,3 | 0,97 | 0,19 | 0,06 | 28 | 9 | 68 | 7 | 719 | 931 | 28,5 | 93/0806 | 0,996 |
|  |  |  |  |  |  |  |  |  |  |  |  |  |  |  |  |
| R | **Erf** | Rest | 45,1 | 1 | 0,1 | 0,19 | 26 | 8 | 63 | 5 | 714 | 945 | 26,7 | 93/0848 | 0,842 |
| S | **Erf** | Rest | 47,15 | 0,99 | 0,1 | 0,2 | 18 | 9 | 67 | 5 | 718 | 938 | 27,7 | 93/0849 | 0,915 |
| T | **Erf** | Rest | 47,6 | 1 | 0,1 | 0,21 | 27 | 9 | 56 | 5 | 719 | 940 | 27,8 | 93/0850 | 0,932 |
| U | **Erf** | Rest | 48,1 | 1 | 0,1 | 0,21 | 20 | 9 | 76 | 5 | 719 | 935 | 28,2 | 93/0851 | 0,952 |
| V | **Erf** | Rest | 49,8 | 0,95 | 0,09 | 0,06 | 23 | 9 | 56 | 8 | 719 | 934 | 27,8 | 93/0805 | 1,014 |

Tabelle 1 zeigt die Zusammensetzung (in Gew. % bzw. ppm), die Lage der Phasenübergänge und den elektrischen Widerstand im geglühten Zustand der erfindungsgemäßen Beispiele (Erf) und der Referenzen (R).

Die Angabe T($\alpha$'/$\alpha$) bezeichnet den Übergang von der geordneten ferritischen Phase ($\alpha$') in die ungeordnete ferritische Phase ($\alpha$). Dieser Übergang, der charakteristisch ist für FeCo-Legierungen mit Co-Gehalten zwischen 30 Gew. % und 55 Gew. %, ist von der Zusammensetzung abhängig und liegt typischerweise oberhalb von 700°C. Die genaue Lage dieses Übergangs ist z.B. für die Fertigung von Bandmaterial von Bedeutung, da das Abschrecken vor der Kaltverformung von einer Temperatur oberhalb dieses Übergangs erfolgen muss.

Die Temperatur T($\alpha$/$\alpha$+$\gamma$) kennzeichnet den Übergang von dem ferritischen Gebiet (a) in das ferritisch/austenitische Mischgebiet ($\alpha$+$\gamma$). Auch dieser Übergang ist von der Zusammensetzung abhängig. Eine Glühung oberhalb dieses Phasenübergangs geht im System FeCoV typischerweise mit einer deutlichen Verschlechterung der weichmagnetischen Eigenschaften einher.

Die Bestimmung dieser Phasenübergänge kann durch thermische Methoden wie Dilatometrie oder thermische Differenzkalorimetrie (DSC) erfolgen. Je nach Methode und Parameter können die so bestimmten Phasenübergänge um wenige Grad Celsius voneinander abweichen. Für die hier beschriebenen Zusammensetzungen wurden die Phasenübergänge mittels DSC bestimmt, wobei für den Übergang T($\alpha$'/$\alpha$) der Peak des entsprechenden Signals beim Aufheizen und für T($\alpha$/$\alpha$+$\gamma$) der erste Onset beim Abkühlen verwendet wurde.

Der elektrische Widerstand $\rho_{el}$ wurde im geglühten Zustand gemessen, wobei die Glühung im ferritischen $\alpha$-Gebiet stattfand. Die Glühtemperatur lag bei 880°C, mit Ausnahme von Zusammensetzung B, für die eine Glühtemperatur von 850°C gewählt wurde.

Die Ausführungsbeispiele A, B, C stellen Referenzen dar, die Beispiele D bis I erfindungsgemäße Zustände.

Die Zusammensetzung A weist 48,7 Gew. % Co, 1,87% V, 0,09% Nb, 0,17 Gew. % Mn und Rest Fe auf und entspricht somit im Wesentlichen der in GB2495465B offenbarten Zusammensetzung. Diese Legierung ist kommerziell unter dem Namen VACODUR 49 erhältlich. Der Phasenübergang T($\alpha$/$\alpha$+$\gamma$) liegt bei 889°C, der Ordnungs-/Unordnungsübergang T($\alpha$'/$\alpha$) bei 717°C. Der elektrische Widerstand beträgt 42,8 $\mu\Omega$cm, d.h. oberhalb von 40 $\mu\Omega$cm.

Bei der Zusammensetzung B wurde bei ähnlichen Gehalten an Co, Nb und Mn der V-Gehalt auf 2,49 Gew. % erhöht. Damit einher geht eine deutliche Absenkung des Phasenübergangs T($\alpha$/$\alpha$+$\gamma$) auf 830°C und eine Erhöhung des elektrischen Widerstands auf 48,6 $\mu\Omega$cm.

Die Zusammensetzung C entspricht einer Variante ganz ohne V. Da die rein binäre FeCo-Legierung nicht kaltwalzbar ist, wurde hier durch 0,30 Gew. % Nb eine ausreichende Duktilität sichergestellt. Der Phasenübergang T($\alpha$/$\alpha$+$\gamma$) dieser Legierung liegt durch den vollständigen Verzicht auf V relativ hoch bei 978°C. Gleichzeitig steigt der Ordnungs-/Unordungsübergang T($\alpha$'/$\alpha$) auf 735°C. Durch den vollständigen Mangel an V liegt der elektrische Widerstand mit 6,1 $\mu\Omega$cm auf dem Niveau einer binären FeCo-Legierung, d.h. sehr niedrig.

Die Variante D entspricht einem erfindungsgemäßen Beispiel A mit einem auf 1,4 Gew. % reduzierten V-Gehalt. Durch diese Absenkung im V-Gehalt wird der Phasenübergang T($\alpha$/$\alpha$+$\gamma$) bereits auf 921°C erhöht. Der elektrische Widerstand wiederum sinkt auf 35,2 $\mu\Omega$cm.

Die erfindungsgemäßen Zusammensetzungen E, F, G, H und I weisen Co-Gehalte zwischen 48,5 Gew. % und 49 Gew. % Co und Nb-Gehalte zwischen 0,08 Gew. % und 0,10 Gew. % auf. Der V-Gehalt variiert von 1,20 Gew. % für Beispiel E bis zu 0,49 Gew. % bei Beispiel I. Der Mn-Gehalt ist bei allen Zusammensetzungen ähnlich bei etwa 0,2 Gew. %. In einer Großschmelze können diese Mn-Zusätze deutlich geringer ausfallen. Der Phasenübergang T($\alpha$/$\alpha$+$\gamma$) liegt zwischen 928°C und 954°C und steigt mit abnehmendem V-Gehalt, während der elektrische Widerstand bis auf 18,4 $\mu\Omega$cm fällt.

Es ist prinzipiell natürlich möglich, die erfindungsgemäßen Zusammensetzungen weiter zu variieren. In weiteren Ausführungsbeispielen sind geringe Zugaben von unterschiedlichen Elementen zur Anhebung des elektrischen Widerstands hinzugefügt. In einem Beispiel wird Mo, W, Cr, Mn in Mengen von jeweils bis zu 0,5 Gew. % und Si, Al jeweils bis zu 0,3 Gew. % hinzugefügt. Dabei wird die Zulegierung stets so bemessen, dass die Temperatur des Phasenübergangs T($\alpha$/$\alpha$+$\gamma$) nicht unter 900°C gedrückt wird.

Heiß- und Kaltverarbeitung

Gussblöcke mit den genannten Zusammensetzungen wurden mittels Vakuumschmelzen (VIM) erschmolzen, oberflächlich gefräst und anschließend bei Einlegetemperaturen zwischen 1000°C und 1200°C an eine Dicke von 1,5 mm bis 3,5 mm, vorzugsweise weniger als 2,5 mm oder weniger als 2,0 mm warmgewalzt.

Nach dem Warmwalzen liegt das Band in einem geordneten bis teilgeordneten Zustand vor und in diesem Zustand ist keine ausreichende Kaltwalzbarkeit gegeben. Im nachfolgenden Schritt wurden daher die warmgewalzten Bänder nach einer Glühung bei $T_1$=820°C für eine Dauer von ≤ 1h durch rasches Eintauchen in ein Eis-Salzwassergemisch abgeschreckt, um die Ordnungseinstellung zu unterdrücken und eine weitere Kaltverformung zu ermöglichen.

Die Temperatur $T_1$ der Abschreckung muss oberhalb des Ordnungs-/Unordnungsübergangs T($\alpha$'/$\alpha$) liegen, damit bei der Glühung die Ordnung aufgehoben wird und dieser Zustand durch das Abschrecken möglichst erhalten bleibt. Für eine Fertigung von Bändern im großtechnischen Maßstab muss $T_1$ zudem ausreichend hoch gewählt sein, damit genügend Zeit bleibt, das Band in das Abschreckbad einzutauchen. Die Temperatur der Abschreckung wurde in diesen Beispielen mit 820°C ausreichend hoch gewählt, so dass dies bei allen Proben sicher gelingt.

Andererseits muss $T_1$ aber ausreichend niedrig liegen, damit das Kornwachstum gering ausfällt, da sich grobes Korn negativ auf die Kaltverarbeitbarkeit auswirkt. Zur Vermeidung des Kornwachstums kann die Haltezeit an Abschrecktemperatur begrenzt werden, in diesem Beispiel auf 1 h. In einer großtechnischen Fertigung kann es aber erforderlich sein, das Band für mehrere Stunden auf Temperatur zu halten, um ein gleichmäßiges Erwärmen des gesamten Bands zu gewährleisten. Daher kann es sinnvoll sein, das Kornwachstum zusätzlich durch Zugaben an Nb und/oder Ta zu verringern. In manchen Ausführungsbeispielen wurden Gehalte an Nb von etwa 0,1 Gew. % gewählt. Ein Niob-Gehalt zwischen 0,04 Gew. % und 0,1 Gew. % wurde als vorteilhaft gefunden. Alternativ kann z.B. Ta verwendet werden, wobei hier auf Grund des höheren Atomgewichts in etwa die doppelte Menge verwendet werden muss.

Die weiteren Parameter der Abschreckung, z.B. die Salzkonzentration, die Wassermenge im Verhältnis zur Probe und die Menge an Eis zur Abkühlung, wurden so gewählt, dass im Temperaturbereich bis mindestens 100°C Abschreckgeschwindigkeiten von 1000 °C/h oder mehr resultierten. Die Einhaltung dieser hohen Abschreckrate ist dabei entscheidend für die erfolgreiche Unterdrückung der Ordnungseinstellung.

Durch die Kombination der genannten Maßnahmen wurde die Ordnungseinstellung weitestgehend unterdrückt und es resultierte ein feinkörniges Gefüge. Alle Zusammensetzungen, auch die mit geringem V-Gehalt, konnten auf diese Weise ausreichend duktilisiert werden, so dass eine Weiterverarbeitung möglich war.

Die Warmwalzhaut der abgeschreckten Bänder wurde durch Beizen bzw. Sandstrahlen entfernt. An Bändern größeren Maßstabs kann das Entfernen loser Oxide auch z.B. durch Kugelstrahlen erfolgen.

Anschließend wurden die Bänder kaltgewalzt. Während das Kaltwalzen bei dem Referenzzustand A mit 1,89 Gew. % ohne Probleme gelang, kam es insbesondere bei den Bändern mit einem V-Gehalt unter 1,4 Gew. %, zur Rissbildung. Es ist bekannt, dass die Zulegierung von V zu FeCo zu einer Verbesserung der Duktilität nach dem Abschrecken führt. Die kommerziellen Legierungen haben daher V-Gehalte zwischen 1,8 Gew. % und 2,0 Gew. %, um eine ausreichende Verarbeitbarkeit zu gewährleisten.

Es wurden zwei Möglichkeiten identifiziert, trotz eines verringerten V-Gehalts unterhalb von 1,5 Gew. % diese Rissbildung deutlich zu reduzieren und eine Kaltwalzbarkeit sicherzustellen:

Anwärmen des Bands vor dem Kaltwalzen auf eine Temperatur von bis zu 300°C, vorzugsweise mindestens auf 30°C und maximal bis zu 200°C, vorzugsweise mindestens auf 50°C und maximal bis zu 200°C. Durch die Erwärmung wird die Streckgrenze heruntergesetzt und das Material lässt sich besser plastisch verformen. Bei Erwärmung des Bands über 200°C kommt es aber zur allmählichen Versprödung des Bands, so dass die Anwärmtemperatur so gering wie nötig sein sollte und die Erwärmungsdauer möglichst auf die zur vollständigen Durcherwärmung benötigte Zeit beschränkt werden sollte.

Zudem erwies es sich bei den Bändern mit 1,4 Gew. % V oder geringerem V-Gehalt, beispielsweise zwischen 0,6 Gew. % und 1,35 Gew. % oder zwischen 0,8 Gew. % und 1,2 Gew. % als äußerst vorteilhaft, wenn die Warmwalzdicke möglichst gering war, da dann eine durchgehende Verformung im ersten Kaltwalzstich sichergestellt werden konnte. Konkret waren die Bänder mit einer Warmwalzdicke von 1,8 mm deutlich besser verformbar als die Bänder mit einer Warmwalzdicke von 3,5 mm. In einer großtechnischen Fertigung ist eine Warmwalzdicke von unter 2,5 mm, besser noch unter 2,0 mm anzustreben.

Nach etwa 20% Kaltverformung konnten alle Bänder ohne Probleme weiterverarbeitet werden. Die Bänder wurden in mehreren Stichen an eine Enddicke von etwa 0,35 mm bzw. 0,15 mm kaltgewalzt. Dabei können in den Fertigungsablauf nach Bedarf noch Schleif- oder Beizschritte eingefügt werden, um die Oberflächenqualität weiter zu verbessern.

Glühung und Magnetik

Aus den kaltgewalzten Bändern wurden Probenringe der Abmessung Ø28,5 mm x Ø20,0 mm gestanzt. Die so erhaltenen Ringe wurden verschiedenen magnetischen Schlussglühungen unterzogen und in Anlehnung an die Messnorm IEC 60404-4 bzw. IEC 60404-6 magnetisch charakterisiert.

In Tabelle 2 sind die Magnetwerte von Proben der Zusammensetzungen A bis I bei verschiedenen Schlussglühungen zusammengestellt. Die Glühungen werden entsprechend der jeweiligen Zusammensetzung durchnummeriert, z.B. A1 und A2 für die Zusammensetzung A. Die Spalte R/Erf kennzeichnet, ob sowohl die Zusammensetzung der Legierung erfindungsgemäß ist, als auch das angewandte Glühverfahren erfindungsgemäß ist (Erf) oder wenn nicht beide Bedingungen erfüllt sind, dann nur eine Referenz darstellt (R).

Alle Glühungen erfolgten stets unter trockenem Wasserstoff bei einer Haltetemperatur Tmax und einer Haltedauer t. Das Abkühlen von Tmax bis etwa 400°C erfolgte mit einer Geschwindigkeit von 100°C/h bis 200°C/h. Die Abkühlrate kann auch variiert werden, wobei Abkühlraten über 1000°C/h nicht zu empfehlen sind, da es hierbei zu Spannungen im Material kommen kann, die zu einer Verringerung der Permeabilität führen.

Für jede Zusammensetzung wurde eine Glühung bei einer Haltetemperatur von 880°C durchgeführt, da diese Glühtemperatur dem aktuellen Stand der Technik entspricht. Zudem wurde mindestens eine zweite Glühung bei abweichender Glühtemperatur durchgeführt. Die Haltezeit lag bei 4 oder 6 h, in Einzelfällen sogar bei 12 h. In einigen Fällen wurden noch Proben an Dicke 0,15 mm geglüht.

Die ermittelten magnetischen Kenngrößen sind die Koerzitivfeldstärke Hc, die Remanenz Br, die Maximalpermeabilität $\mu_{max}$, die Induktionswerte B(H) mit B3, B8, B24, B80, B160 bei Feldstärken von H=3 A/cm, 8 A/cm, 24 A/cm, 80 A/cm und 160 A/cm, sowie die aus B160 berechnete Polarisation J160 bei H=160 A/cm, die als gute Näherung für die erreichbare Sättigungspolarisation gesehen werden kann. Eine im Sinne der Erfindung gute Probe weist eine niedrige Koerzitivfeldstärke Hc, eine hohe Maximalpermeabilität $\mu_{max}$, hohe Induktionen B(H) und eine möglichst hohe Sättigung J160 auf.

Für die Referenzprobe A mit der Zusammensetzung der kommerziellen Legierung VACODUR 49 wird vom Hersteller eine maximale Schlussglühtemperatur von 880°C empfohlen. In A1 erkennt man, dass hiermit bereits relativ gute weichmagnetische Eigenschaften resultieren, d.h. ein Hc von 31,6 A/m und eine Permeabilität von 22.971. Durch den V-Gehalt von fast 1,9 Gew. % liegt die Sättigung J160 unterhalb von 2,3 T. Erhöht man wie in Beispiel A2 die Schlussglühtemperatur auf 890°C, so glüht man am unteren Rand des Zweiphasengebiets $\alpha+\gamma$, da die Übergangstemperatur $T(\alpha/\alpha+\gamma)$ laut DSC-Ergebnis bei 889°C liegt. Es ergibt sich eine deutliche Verschlechterung der magnetischen Eigenschaften, d.h. eine Erhöhung des Hc auf 53 A/m und eine Abnahme von $\mu_{max}$ auf 6.499. Es wird davon ausgegangen, dass dies auf eine Entmischung bei der Glühung zurückzuführen ist, da sich an den Korngrenzen eine leicht erhöhte Konzentration an V findet. Das Beispiel illustriert, dass bei FeCoV-Legierungen eine Überschreitung des Phasenübergangs nicht sinnvoll ist.

Bei Probe B liegt die in Glühung B1 gewählte Glühtemperatur von 880°C bereits im $\alpha+\gamma$ Mischgebiet. Die Koerzitivfeldstärke ist mit 220 A/m entsprechend hoch. Eine deutlich bessere Glühung ist das Beispiel B2 bei 830°C, was bei der Zusammensetzung noch im $\alpha$-Gebiet liegt. Das Hc ist mit 55,7 A/m aber deutlich höher als beim Referenzbeispiel A1. Bei dieser Zusammensetzung lässt sich also das erfindungsgemäße Glühverfahren nicht einsetzen, da der Phasenübergang $T(\alpha/\alpha+\gamma)$ unterhalb von 900°C liegt.

Die V-freie Variante C zeigt im Beispiel C1 nach einer Glühung bei 880°C noch einen sehr hohen Hc-Wert von 107 A/m. Durch die hohe Temperatur des Übergangs $\alpha/\alpha+\gamma$ ist eine Glühung bei deutlich höherer Glühtemperatur von bis zu 970°C möglich. Trotzdem liegen die Kennwerte mit einem Hc von 56,9 A/m und $\mu_{max}$ von 11.034 schlechter als die Referenzglühung A1.

Das Beispiel C zeigt auf, dass die alleinige Anhebung der Glühtemperatur auf über 900°C noch nicht zwangsläufig zu einer Verbesserung der weichmagnetischen Eigenschaften führt. Eine angepasste Zusammensetzung sollte gleichzeitig verwendet werden, um die weichmagnetischen Eigenschaften zu verbessern.

Die erfindungsgemäße Zusammensetzung D mit 1,4 Gew. % V erreicht im Beispiel D1 bei der Standardglühung 880°C nahezu identische Kennwerte zum Referenzbeispiel A1 mit 1,9 Gew. % V. Die Sättigung J160 liegt auf Grund der abgesenkten Zulegierungsmenge bereits über 2,31 T. Durch den angehobenen Phasenübergang ist hier auch eine höhere Glühtemperatur über 900°C möglich. Das Beispiel D2 zeigt, dass durch eine Glühung bei 910°C bei gleicher Glühdauer bereits eine Verbesserung der Kennwerte erfolgt ist.

Bei der erfindungsgemäßen Zusammensetzung E mit 1,2 Gew. % V ergeben sich bei einer Glühung bei 880°C im Beispiel E1 noch magnetische Kennwerte, die denen der Referenz A1 entsprechen, z.B. das Hc von 31,7 A/m. Die Sättigung J160 ist durch den abgesenkten V-Gehalt mit über 2,33 T aber deutlich höher. Durch den bei 930°C liegenden Phasenübergang $\alpha/\alpha+\gamma$ ist eine Glühung bei deutlich höherer Temperatur möglich als bei der Zusammensetzung A. In Beispiel E2 wird bei einer Haltetemperatur von 920°C eine deutlich reduzierte Koerzitivfeldstärke Hc von 27,1 A/m erreicht. Bei diesem V-Gehalt ist die mögliche Glühtemperatur also bereits soweit angehoben worden, dass ein deutlicher Vorteil gegenüber dem Stand der Technik deutlich wird.

Die Glühung E3 wurde wie E2 bei einer Haltetemperatur von 920°C durchgeführt, allerdings mit verlängerter Haltezeit von 12 h. Diese für eine Serienfertigung immer noch akzeptable Haltedauer führt nochmal zu einer wesentlichen Verbesserung, insbesondere hinsichtlich der Koerzitivfeldstärke, die auf 22,9 A/m sinkt.

Für die Zusammensetzung F mit 1,1 Gew. % V ergibt sich für die beiden Glühungen F1 bei 880°C bzw. F2 bei 920°C ein ähnlicher Effekt, d.h. durch die Erhöhung der Glühtemperatur kann das Hc deutlich abgesenkt und $\mu_{max}$ deutlich angehoben werden. Im Glühbeispiel F3 resultiert aus der längeren Haltezeit von 12h eine sehr geringes Hc von nur 21,5 A/m.

Die vier Glühungen der Variante G mit 0,97 Gew. % V zeigen zum einen den Effekt der Erhöhung der Glühtemperatur auf, d.h. G2 ist besser als G1 und G4 ist besser als G3. Zusätzlich wird hier noch der positive Effekt einer stärkeren Kaltverformung deutlich, d.h. die 0,15 mm dünne Probe G4 spricht auf die Glühung bei höherer Temperatur besser an und es resultiert ein sehr guter Hc-Wert von nur 16,2 A/m und eine Maximalpermeabilität von 32.596.

Bei der Zusammensetzung H ist dieser Effekt sogar noch deutlicher. Durch die Erhöhung der Glühtemperatur auf 940°C in Kombination mit dem niedrigen V-Gehalt von nur 0,70 Gew. % ergeben sich in den Ausführungsbeispielen H2 und H4 Koerzitivfeldstärken Hc von unter 20 A/m und eine Maximalpermeabilität von über 39.000. Gleichzeitig liegt die Sättigung J160 bei etwa 2,35 T. Die Probe H2 wurde vor der erfindungsgemäßen Glühung bei 940°C vorab 6h lang bei 880°C geglüht. Man erkennt, dass hier kein wesentlicher Vorteil gegenüber der Probe I4 resultiert, die nur bei 940°C geglüht wurde. Entscheidend ist also die Erhöhung der Glühtemperatur, nicht die mehrfache Glühung der Probe.

Für die erfindungsgemäße Zusammensetzung I mit dem niedrigsten V-Gehalt von 0,49 Gew. % ist der Effekt der höheren Glühung ebenfalls gut ersichtlich, d.h. während mit der Referenzglühung I1 bei 880°C nur eine Maximalpermeabilität von 24.666 erreicht wird, erzielt die bei 950°C geglühte Probe eine deutlich höhere Permeabilität von 33.269.

Die Beispiele I3 und I4 zeigen auf, dass auch bei sehr niedrigem V-Gehalt eine Glühung oberhalb des Phasenübergangs $T(\alpha/\alpha+\gamma)$ nicht sinnvoll ist. Der gemessene Phasenübergang liegt bei 954°C und eine Glühung bei 960°C führt bereits zu einem Anstieg im Hc auf 40,3 A/m. Auch eine Glühung bei 1050°C, die voll im austenitischen $\alpha$-Gebiet liegt, führt zu einer Verschlechterung im Hc auf 59,6 A/m.

Tabelle 2

| | R/Erf | d mm | Tmax °C | t h | Hc A/m | Br T | $\mu_{max}$ | B1 T | B3 T | B8 T | B24 T | B80 T | B160 T | J160 T | Probe |
|---|---|---|---|---|---|---|---|---|---|---|---|---|---|---|---|
| A1 | R | 0,35 | 880 | 6 | 31,6 | 1,50 | 22.971 | 1,791 | 2,044 | 2,177 | 2,254 | 2,285 | 2,305 | 2,285 | 1802188 |
| A2 | R | 0,35 | 890 | 6 | 53,0 | 0,79 | 6.499 | 0,771 | 1,267 | 1,670 | 2,020 | 2,216 | 2,270 | 2,249 | 1905377 |
| B1 | R | 0,35 | 880 | 6 | 220 | 0,63 | 1.212 | | 0,452 | 0,877 | 1,388 | 1,884 | 0,877 | 2,057 | 1802187 |
| B2 | R | 0,35 | 830 | 6 | 55,7 | 1,34 | 11.734 | | 1,878 | 2,088 | 2,199 | 2,248 | 2,265 | 2,245 | 1802203 |
| C1 | R | 0,35 | 880 | 6 | 107 | 1,63 | 8.502 | | 1,918 | 2,173 | 2,310 | 2,370 | 2,390 | 2,369 | 2001897 |
| C2 | R | 0,35 | 970 | 4 | 56,9 | 1,38 | 11.034 | | 1,940 | 2,167 | 2,315 | 2,375 | 2,392 | 2,371 | 1900141 |
| D1 | R | 0,35 | 880 | 6 | 32,6 | 1,68 | 23.733 | | 2,092 | 2,231 | 2,298 | 2,328 | 2,343 | 2,323 | 2002581 |
| D2 | Erf | 0,35 | 910 | 6 | 28,1 | 1,65 | 25.071 | 1,873 | 2,126 | 2,251 | 2,305 | 2,328 | 2,342 | 2,322 | 2002593 |
| E1 | R | 0,35 | 880 | 6 | 31,7 | 1,64 | 23.016 | | 2,085 | 2,242 | 2,311 | 2,341 | 2,356 | 2,336 | 2002580 |
| E2 | Erf | 0,35 | 920 | 6 | 27,1 | 1,67 | 25.326 | 1,853 | 2,124 | 2,261 | 2,317 | 2,341 | 2,354 | 2,334 | 2002588 |
| E3 | Erf | 0,35 | 920 | 12 | 22,9 | 1,61 | 27.498 | 1,843 | 2,129 | 2,269 | 2,318 | 2,340 | 2,353 | 2,333 | 2002592 |
| F1 | R | 0,35 | 880 | 6 | 29,0 | 1,74 | 26.317 | | 2,114 | 2,235 | 2,309 | 2,341 | 2,357 | 2,336 | 2002579 |
| F2 | Erf | 0,35 | 920 | 6 | 26,2 | 1,81 | 31.589 | 1,966 | 2,142 | 2,251 | 2,317 | 2,343 | 2,357 | 2,337 | 2002587 |
| F3 | Erf | 0,35 | 920 | 12 | 21,5 | 1,79 | 37.110 | 1,988 | 2,157 | 2,260 | 2,319 | 2,343 | 2,356 | 2,336 | 2002591 |
| G1 | R | 0,35 | 880 | 6 | 28,7 | 1,57 | 23.948 | | 2,057 | 2,243 | 2,316 | 2,344 | 2,356 | 2,336 | 1802190 |
| G2 | Erf | 0,35 | 925 | 6 | 24,7 | 1,56 | 26.514 | 1,757 | 2,069 | 2,249 | 2,323 | 2,351 | 2,364 | 2,344 | 1804102 |
| G3 | R | 0,15 | 880 | 6 | 28,2 | 1,49 | 21.351 | | 1,897 | 2,117 | 2,251 | 2,316 | 2,337 | 2,317 | 1900151 |
| G4 | Erf | 0,15 | 925 | 6 | 16,3 | 1,62 | 32,596 | 1,767 | 2,006 | 2,222 | 2,310 | 2,335 | 2,347 | 2,327 | 1905349 |
| H1 | R | 0,35 | 880 | 6 | 27,9 | 1,52 | 23.102 | | 1,995 | 2,231 | 2,321 | 2,351 | 2,372 | 2,352 | 1802191 |
| H2 | Erf | 0,35 | 940 | 4 | 19,9 | 1,62 | 39.580 | 1,797 | 2,073 | 2,278 | 2,337 | 2,357 | 2,368 | 2,348 | 1802191 |
| H3 | R | 0,15 | 880 | 6 | 27,0 | 1,57 | 24.392 | | 1,972 | 2,187 | 2,302 | 2,348 | 2,364 | 2,344 | 1900152 |
| H4 | Erf | 0,15 | 940 | 6 | 16,2 | 1,68 | 39.479 | 1,790 | 2,009 | 2,236 | 2,330 | 2,354 | 2,368 | 2,348 | 1905347 |
| I1 | R | 0,35 | 880 | 6 | 28,5 | 1,58 | 24.666 | | 2,006 | 2,254 | 2,343 | 2,374 | 2,388 | 2,368 | 1802192 |
| I2 | Erf | 0,35 | 950 | 4 | 18,3 | 1,64 | 33.269 | 1,807 | 2,061 | 2,278 | 2,344 | 2,366 | 2,381 | 2,361 | 1802206 |
| I3 | R | 0,15 | 960 | 6 | 40,3 | 1,69 | 22.903 | | 1,993 | 2,219 | 2,327 | 2,363 | 2,377 | 2,356 | 1905381 |

EP 4 027 357 A1

(fortgesetzt)

| | R/Erf | d mm | Tmax °C | t h | Hc A/m | Br T | $\mu_{max}$ | B1 T | B3 T | B8 T | B24 T | B80 T | B160 T | J160 T | Probe |
|---|---|---|---|---|---|---|---|---|---|---|---|---|---|---|---|
| I4 | R | 0,35 | 1050 | 6 | 59,6 | 1,47 | 10.606 | | 1,831 | 2,148 | 2,303 | 2,346 | 2,389 | 2,369 | 1701536 |
| J1 | Erf | 0,35 | 935 | 6 | 20,8 | 1,59 | 30.135 | 1,765 | 2,069 | 2,277 | 2,336 | 2,356 | 2,369 | 2,349 | 2100285 |
| J2 | Erf | 0,1 | 935 | 6 | 17,3 | 1,66 | 39.310 | 1,831 | 2,075 | 2,256 | 2,327 | 2,356 | 2,371 | 2,351 | 2100286 |
| K1 | R | 0,35 | 925 | 6 | 21,6 | 1,67 | 36.720 | 1,948 | 2,144 | 2,272 | 2,333 | 2,357 | 2,370 | 2,350 | 2100311 |
| K2 | R | 0,1 | 925 | 6 | 20,3 | 1,55 | 31.025 | 1,756 | 2,037 | 2,221 | 2,323 | 2,359 | 2,374 | 2,354 | 2100319 |
| L1 | Erf | 0,35 | 920 | 6 | 22,9 | 1,81 | 34.640 | 1,942 | 2,120 | 2,246 | 2,323 | 2,351 | 2,362 | 2,342 | 2100308 |
| L2 | Erf | 0,1 | 920 | 6 | 24,1 | 1,67 | 32.980 | 1,804 | 2,042 | 2,203 | 2,312 | 2,351 | 2,364 | 2,344 | 2100317 |
| M1 | Erf | 0,35 | 920 | 6 | 26,9 | 1,78 | 29.219 | 1,920 | 2,113 | 2,238 | 2,316 | 2,346 | 2,361 | 2,341 | 2100307 |
| M2 | Erf | 0,1 | 920 | 6 | 27,6 | 1,65 | 28.286 | 1,770 | 2,022 | 2,189 | 2,301 | 2,345 | 2,361 | 2,341 | 2100318 |
| N1 | Erf | 0,35 | 915 | 6 | 28,6 | 1,81 | 28.709 | 1,931 | 2,116 | 2,238 | 2,316 | 2,348 | 2,362 | 2,342 | 2102028 |
| N2 | Erf | 0,1 | 915 | 6 | 29,5 | 1,86 | 29.435 | 1,965 | 2,146 | 2,252 | 2,321 | 2,351 | 2,366 | 2,346 | 2102030 |
| O1 | Erf | 0,35 | 915 | 6 | 28,0 | 1,63 | 25.894 | 1,893 | 2,105 | 2,229 | 2,305 | 2,335 | 2,351 | 2,331 | 2102050 |
| O2 | Erf | 0,1 | 915 | 6 | 24,9 | 1,70 | 31.131 | 1,902 | 2,120 | 2,242 | 2,312 | 2,339 | 2,353 | 2,333 | 2102052 |
| P1 | Erf | 0,35 | 910 | 6 | 23,4 | 1,70 | 33.200 | 1,964 | 2,138 | 2,244 | 2,304 | 2,328 | 2,341 | 2,321 | 2101973 |
| P2 | Erf | 0,1 | 910 | 6 | 23,6 | 1,64 | 31.790 | 1,840 | 2,060 | 2,199 | 2,291 | 2,328 | 2,344 | 2,324 | 2102047 |
| Q1 | R | 0,35 | 925 | 6 | 49,8 | 1,53 | 14.149 | 1,623 | 1,998 | 2,174 | 2,293 | 2,339 | 2,356 | 2,336 | 2102018 |
| R1 | Erf | 0,35 | 920 | 6 | 32,0 | 1,49 | 18.300 | 1,374 | 1,622 | 1,861 | 2,185 | 2,360 | 2,368 | 2,348 | 2106020 |
| S1 | Erf | 0,35 | 920 | 6 | 27,9 | 1,49 | 23.027 | 1,435 | 1,690 | 1,968 | 2,305 | 2,355 | 2,361 | 2,341 | 2106019 |
| T1 | Erf | 0,35 | 920 | 6 | 27,8 | 1,50 | 24.787 | 1,487 | 1,757 | 2,053 | 2,325 | 2,354 | 2,359 | 2,339 | 2106021 |
| U1 | Erf | 0,35 | 920 | 6 | 26,3 | 1,53 | 26.969 | 1,569 | 1,860 | 2,166 | 2,331 | 2,353 | 2,358 | 2,338 | 2106018 |
| V1 | Erf | 0,35 | 925 | 6 | 36,3 | 0,87 | 14.674 | 1,606 | 1,929 | 2,125 | 2,278 | 2,339 | 2,359 | 2,339 | 2102016 |

Tabelle 2 zeigt die statischen Kennwerte in Abhängigkeit von der Glühung bei erfindungsgemäßen Glühtemperaturen (Erf) bzw. Referenzglühungen (R).

Neben den statischen Kennwerten wurden auch die Ummagnetisierungsverluste zwischen 50 Hz und 1000 Hz betrachtet. Die Verluste bei niedrigen Frequenzen, z.B. 50 Hz, sind im Wesentlichen von den Hystereseverlusten $P_H$ bestimmt. Auf Grund der Beziehung

$$P_H \propto H_c$$

ist für die Erzielung niedriger Verluste eine niedrige Koerzitivfeldstärke Hc notwendig. Bei hohen Frequenzen, z.B. bei 1 kHz, sind die Verluste vor allem durch die Wirbelstromverluste $P_{eddy}$ bestimmt. Diese sind proportional zum Quadrat der Banddicke d und umgekehrt proportional zum elektrischen Widerstand $\rho_{el}$:

$$P_{eddy} \propto \frac{d^2}{\rho_{el}}$$

Für niedrige Verluste bei hohen Frequenzen ist daher das Verhältnis aus der Banddicke zum Quadrat zum elektrischen Widerstand ausschlaggebend.

In Tabelle 3 sind die an ausgewählten Proben gemessenen Ummagnetisierungsverluste $P_{Fe}$ für die Induktionen $B_{max}$ von 1,5 T bzw. 2,0 T mit den Frequenzen 50 Hz, 400 Hz und 1000 Hz aufgeführt. Dabei bezeichnet z.B. $P_{Fe}$(2.0 T, 400 Hz) die gemessenen Verluste $P_{Fe}$ bei einer maximalen Induktion $B_{max}$ von 2,0 T und einer Frequenz von 400 Hz. Bei einigen Zusammensetzungen und Banddicken konnten die Verluste bei 400 Hz nicht gemessen werden, da die absoluten Verluste zu hoch waren für den verwendeten Messplatz.

Die Referenzprobe A1 mit 1,87 Gew. % V zeigt an Banddicke 0,35 mm relativ geringe Verluste, z.B. 1,38 W/kg bei 1,5 T und 50 Hz und 378 W/kg bei 2,0 T und 1 kHz. Die niedrigen Verluste sind hier vor allem auf den hohen elektrischen Widerstand von über 40 $\mu\Omega$cm zurückzuführen.

Die Referenz B2, d.h. die Variante mit erhöhtem V-Gehalt von 2,49 Gew %, zeigt wegen des noch weiter erhöhten elektrischen Widerstands bei gleicher Banddicke geringere Verluste bei 2,0 T und 1kHz als A1. Da die Koerzitivfeldstärke aber höher liegt, sind die Verluste bei 1,5 T und 50 Hz höher.

Die V-freie Referenz C2 nur mit Nb-Zusatz weist über den gesamten Frequenzbereich sehr hohe Verluste aus, da der elektrische Widerstand mit weniger als 10 $\mu\Omega$cm für eine dynamische Anwendung inakzeptabel niedrig liegt.

Das Beispiel G2 mit der der erfindungsgemäßen Zusammensetzung G mit 0,97 Gew. % V zeigt hingegen an Banddicke 0,35 mm und nach einer Glühung bei 925°C deutlich geringere Verluste als dem Vergleichsbeispiel C2 ohne V.

Die Beispiele G3 und G4 illustrieren, dass eine weitere Verbesserung der Verluste möglich ist, indem die Banddicke auf 0,15 mm reduziert wird. Durch die deutliche Verringerung der Dicke liegen die Verlustwerte bei 400 Hz und 1000 Hz unterhalb der Werte des Referenzbeispiels A1. Es zeigt sich, dass insbesondere durch die erfindungsgemäße Glühung bei 925°C auch die Verluste bei 50 Hz unter die der Referenz fallen. Dies ist auf die geringe Koerzitivfeldstärke durch die hohe Glühtemperatur zurückzuführen.

Da die Zusammensetzung H mit nur 0,70 Gew. % bereits einen sehr niedrigen elektrischen Widerstand von nur 22,8 $\mu\Omega$cm aufweist, ist hier die Verwendung einer dünnen Banddicke besonders sinnvoll. Auch hier ergeben sich bei Anwendung der erfindungsgemäßen Glühung bei 925°C im Beispiel H4 durchgehend Verlustwerte, die unter dem Vergleichsbeispiel A1 liegen.

Tabelle 3.

| | R/Erf | d mm | Tmax °C | t h | PFe 1,5 T 50 Hz W/kg | PFe 1,5 T 400 Hz W/kg | PFe 1,5 T 1 kHz W/kg | PFe 2,0 T 50 Hz W/kg | PFe 2,0 T 400 Hz W/kg | PFe 2,0 T 1 kHz W/kg | Probe |
|---|---|---|---|---|---|---|---|---|---|---|---|
| A1 | R | 0,35 | 880 | 6 | 1,38 | 33,8 | 177 | 2,32 | 65,8 | 378 | 1802188 |
| B2 | R | 0,35 | 830 | 6 | 1,86 | 21,6 | 170 | 2,82 | 56,9 | 302 | 1802203 |
| C2 | R | 0,35 | 970 | 4 | 3,23 | 115 | - | 5,58 | 237 | - | 1900141 |
| G2 | Erf | 0,35 | 925 | 6 | 1,76 | 47,5 | 251 | 2,79 | 92,8 | 469 | 1804102 |
| G3 | R | 0,15 | 880 | 6 | 1,57 | 22,9 | 89,9 | 2,43 | 36,6 | 156 | 1900151 |

(fortgesetzt)

| | R/Erf | d mm | Tmax °C | t h | PFe 1,5 T 50 Hz W/kg | PFe 1,5 T 400 Hz W/kg | PFe 1,5 T 1 kHz W/kg | PFe 2,0 T 50 Hz W/kg | PFe 2,0 T 400 Hz W/kg | PFe 2,0 T 1 kHz W/kg | Probe |
|---|---|---|---|---|---|---|---|---|---|---|---|
| G4 | **Erf** | 0,15 | 925 | 6 | 1,18 | 19,9 | 79,1 | 1,78 | 31,6 | 142 | 1905349 |
| H3 | **R** | 0,15 | 880 | 6 | 1,64 | 24,5 | 95,7 | 2,57 | 39,5 | 166 | 1900152 |
| H4 | **Erf** | 0,15 | 925 | 6 | 1,29 | 21,7 | 84,4 | 1,96 | 34,8 | 158 | 1905347 |

Tabelle 3 zeigt die Ummagnetisierungsverluste $P_{Fe}$ in Abhängigkeit von der Glühung bei erfindungsgemäßen Glühtemperaturen (E) bzw. Referenzglühungen (R).

In Figur 4 sind die Ummagnetisierungsverluste $P_{Fe}$/f je Zyklus gegen die Frequenz aufgetragen. Die maximale Induktion $B_{max}$ beträgt 2 T Dabei sind die Punkte bei 50 Hz, 400 Hz und 1000 Hz gesondert markiert, da sie den Messpunkten aus Tabelle 3 entsprechen.

Das Beispiel A1 in 0,35 mm stellt dabei den Referenzzustand dar, sowohl hinsichtlich der V-Zulegierung (1,89 Gew. %) als auch hinsichtlich der Glühung (880°C). Das Beispiel G3 zeigt auf, dass der mit einem reduzierten V-Gehalt von 0,97 Gew. % verbundene Anstieg in den Wirbelstromverlusten überkompensiert werden kann durch eine Verringerung der Banddicke auf 0,15 mm. Dies ist in der Abbildung an dem deutlich flacheren Anstieg der Verlustgerade G3 im Vergleich zu A1 erkennbar.

Da das Hc von Zustand G3 aber ähnlich dem Wert der Referenz A1 ist, liegen auch die Hystereseverluste, d.h. die Schnittpunkte mit der Ordinate, auf dem gleichen Niveau. Durch die Glühung bei 925°C (G4) sinkt die Koerzitivfeldstärke und damit auch die Hystereseverluste. In der Abbildung ist dies an einer Parallelverschiebung nach unten von G4 gegenüber G3 ersichtlich.

Das Beispiel G4 demonstriert, dass mit der erfindungsgemäßen Zusammensetzung G durch Absenkung der Banddicke in Kombination mit der erfindungsgemäßen Glühung Verluste erzielt werden, die im gesamten Frequenzbereich unterhalb der Referenzkurve A1 liegen.

Die Beispiele J bis P stellen Zusammensetzungen dar, wobei die Zusammensetzungen J bis N verschiedene Mn-Gehalte von 0 Gew. % Mn, 0,06 Gew. % Mn und 0,37 Gew. % Mn aufweisen. Die Zusammensetzungen K, L, O und P weisen unterschiedlichen Nb-Gehalte von 0 Gew. % Nb, 0,05 Gew. % Nb und 0,06 Gew. % Nb auf. Die Zusammensetzungen K bis P weisen unterschiedliche Co-Gehalte mit 49,1 Gew. % bis 49,3 Gew. % Co auf.

Die Legierungen der Beispiele J bis P wurden jeweils zu Bändern mit zwei unterschiedlichen Enddicken d = 0,35 mm und 0,1 mm verarbeitet.

Tabelle 2 zeigt, dass die Beispiele J bis P bei einer Schlussglühung mit Tmax>900°C die magnetischen Eigenschaften von J(16 kA/m) ≥ 2,30 T, $\mu_{max}$ > 25.000 und Hc ≤ 30 A/m aufweisen.

Das Beispiel Q weist einen höheren Nb-Gehalt von 0,19 Gew. % auf und zeigt den Effekt eines über den beanspruchten Bereich hinausgehenden Nb-Gehaltes. Wie in Tabelle 2 gezeigt ist, sind die magnetischen Eigenschaften der Legierung trotz einer Schlussglühung mit Tmax>900 °C nicht so gut, weil nur eine Koerzitivfeldstärke Hc von 49,8 A/m und eine Maximalpermeabilität $\mu_{max}$ von 14.149 erreicht werden.

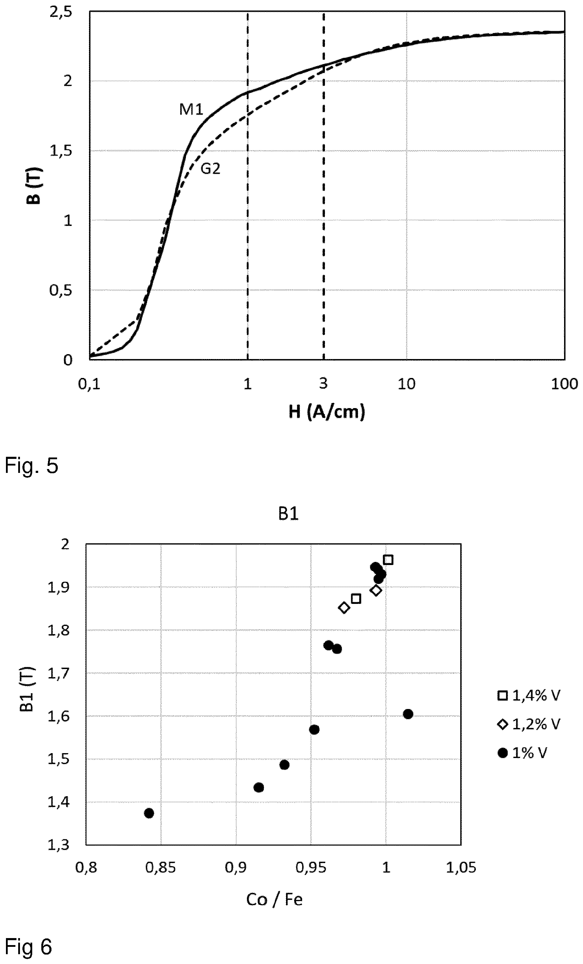

Der Co-Gehalt kann über das Verhältnis aus Co/Fe weiter definiert werden. Eine Analyse der Neukurven bei 0,35mm Banddicke zeigt, dass einige Zusammensetzungen einen abgeflachten Verlauf um H=1 A/cm aufweisen, der besonders in einer logarithmischen Darstellung der Feldstärke sichtbar wird. Dies ist in Figur 5 an den Ausführungsbeispielen G2 und M1 demonstriert. Beide Beispiele G2 und M1 weisen eine sehr ähnliche Zusammensetzung mit 1% V auf. Während die Neukurve von M1 bei H=1 A/cm bereits ein B1 (d.h. B bei H = 1A/cm) von 1,92 T erreicht, verläuft die Neukurve von G2 in diesem Bereich deutlich flacher und erreicht nur einen B1-Wert von 1,757 T. Bei einer Feldstärke von 3 A/cm liegen beide Kurven dagegen wieder nahezu gleichauf und erreichen B3-Werte (d.h. B bei H = 3A/cm) über 2 T. Daher ist der B1-Wert besonders geeignet um den Effekt der abgeflachten Neukurve zu quantifizieren.

Der deutlichste Unterschied in den Zusammensetzungen der Ausführungsbeispiele G und M liegt im Co-Gehalt, welcher in Beispiel G 48,55 % und im Beispiel M 49,3 % beträgt. Daher ist anzunehmen, dass die günstigere Neukurvenform in Beispiel M1 durch den höheren Co-Gehalt erreicht wird.

Der niedrigere Co-Gehalt der Zusammensetzung G liegt aber nahe an der Zusammensetzung A. Die Zusammensetzung A weist im Gegensatz zur Zusammensetzung G keinen abgeflachten Bereich um H=1 A/cm in der Neukurve auf. Trotz des niedrigeren Co-Gehaltes entspricht die Form der Neukurve im Beispiel A1 dem günstigeren Verlauf des Beispiels M1.

Durch die weite Variation des V-Gehaltes verschiebt sich bei gleichbleibendem absoluten Co-Gehalt das Verhältnis aus Co/Fe in den Legierungen stark. Das Verhältnis aus Co/Fe kann in den Legierungen neben der Texturbildung vor allem die Ordnung und damit die magnetokristalline Anisotropie und somit die erzielbaren weichmagnetischen Eigenschaften beeinflussen. Das Verhältnis von Co/Fe wird somit berücksichtigt und wird im Folgenden immer als aus den jeweiligen Gew. % von Co und Fe berechnetes Verhältnis angegeben, ohne bei der Berechnung des Verhältnisses die Verunreinigungsgehalte an C, S, N, O zu berücksichtigen.

In den Zusammensetzungen A und M liegt das Co/Fe-Verhältnis bei einem ähnlich hohen Wert von 0,990 bzw. 0,995. In der Zusammensetzung G mit der abgeflachten Neukurve liegt das Co/Fe-Verhältnis dagegen bei einem niedrigeren Wert von 0,967. Dieses Verhalten wird auch durch andere Ausführungsbeispiele mit 1 % V und 0,35mm Banddicke bestätigt. In Beispiel J1 wird bei einem niedrigen Co/Fe-Verhältnis von 0,961 ebenfalls ein B1 von nur 1,765 T erreicht. In den Beispielen K1, L1 und N1 liegt das Co/Fe-Verhältnis dagegen im Bereich 0,993 bis 0,997 und es werden B1 -Werte durchgehend größer als 1,9 T erreicht.

Durch die Zusammensetzungen R bis V, die ein Co/Fe-Verhältnis von 0,842 bis 1,014 bei gleichbleibendem V-Gehalt von 1 % abdecken, wird der Effekt des Co/Fe-Verhältnisses über einen weiteren Bereich untersucht. Die Legierungen mit den Zusammensetzungen R bis V wurden auf 0,35mm gewalzt und erfindungsgemäß bei Temperaturen über 900 °C und unterhalb des Phasenübergangs $\alpha/\alpha+\gamma$ magnetisch schlussgeglüht. Sie sind als Beispiele R1 bis V1 in Tabelle 2 aufgeführt.

In Tabelle 2 ist ersichtlich, dass bei zu niedrigen oder zu hohen Co/Fe-Verhältnissen die gewünschten magnetischen Eigenschaften nicht erreicht werden können: In Beispiel R1 mit dem niedrigsten Co/Fe-Verhältnis von 0,842 und in Beispiel V1 mit dem höchsten Co/Fe-Verhältnis von 1,014 liegt das Hc jeweils über 30 A/m. In Beispielen R1 bis T1, mit Co/Fe$\leq$0,932 liegt $\mu_{max}$ unter 25.000, ebenso in Beispiel V1 mit dem höchsten Co/Fe-Verhältnis von 1,014. Somit sollte das Co/Fe-Verhältnis zwischen 0,94 und 1,01 liegen, d.h. 0,94 $\leq$ Co/Fe $\leq$ 1,01.

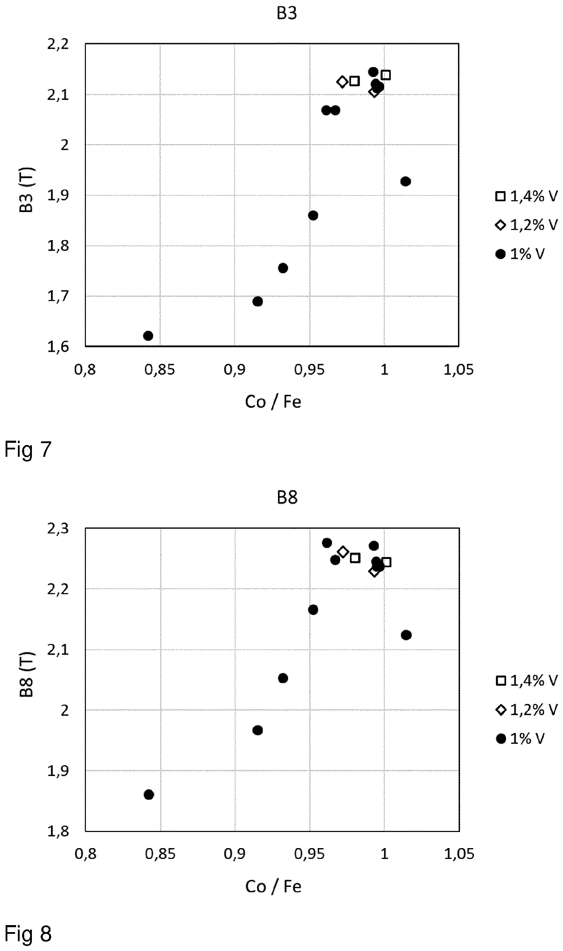

Eine detailliertere Auswertung ist in den Figuren 6 bis 9 gegeben. In diesen werden die magnetischen Kennwerte B1, B3, B8 und die Remanenz Br über das Co/Fe-Verhältnis dargestellt. Die Daten sind dabei nach dem V-Gehalt gruppiert und beziehen auch Beispiele mit V-Gehalten von 1,2 % und 1,4 % ein. Folgende Beispiele aus Tabelle 2 sind in den Abbildungen gezeigt:

| | |
|---|---|
| Eine Zusammensetzung mit 1% V: | G2, J1, K1, L1, M1, N1, R1, S1, T1, U1, V1 |
| Eine Zusammensetzung mit 1,2% V: | E2, O1 |
| Eine Zusammensetzung mit 1,4% V: | D2, P1 |

Eine obere Grenze des Co/Fe-Verhältnisses ist in den Figuren 6 bis 9 durch einen scharfen Abfall der Magnetwerte zwischen Co/Fe $\leq$ 1,000 und Co/Fe=1,014 (Beispiel V1) gegeben. Die Obergrenze des Co/Fe Verhältnisses wird somit auf Co/Fe $\leq$ 1,01 oder vorzugsweise Co/Fe $\leq$ 1,005 gesetzt.

Eine vorteilhafte untere Grenze des Co/Fe-Verhältnisses hängt stark vom betrachteten Kennwert ab:

Der B8-Wert bildet ein Plateau mit gleichbleibend hohem B8>2,2 T zwischen 0,96 $\leq$ Co/Fe $\leq$ 1,00,
Der B3-Wert bildet ein Plateau mit gleichbleibend hohem B3>2,1 T zwischen 0,97 $\leq$ Co/Fe $\leq$ 1,00.
Der B1 -Wert besitzt ein scharfes Maximum B1>1,9 T in einem sehr engen Bereich 0,99 $\leq$ Co/Fe $\leq$ 1,00

Folglich ist ein Co/Fe-Verhältnis zwischen 0,94 und 1,01n, d.h. 0,94 $\leq$ Co/Fe $\leq$ 1,01, vorzugsweise 0,97 $\leq$ Co/Fe $\leq$ 1,005 geeignet, um die gewünschte Kombination von magnetischen Eigenschaften, d.h. hohe Induktionswerte schon bei niedriger Feldstärke H zu erreichen, wobei das Verhältnis Co/Fe aus den jeweiligen Gew. % berechnet wird, ohne bei der Berechnung des Verhältnisses die Verunreinigungsgehalte an C, S, N, O zu berücksichtigen.

Herstellung eines Blechpakets

Bänder aus der erfindungsgemäßen Legierung können für die Anwendung in einer elektrischen Maschine auf unterschiedliche Art weiterverarbeitet werden. Im Folgenden sind Beispiele für die Herstellung von Blechschnitten bzw. von Blechpaketen für die Anwendung in elektrischen Maschinen genannt. Dabei können die vorgestellten Verfahren sowohl für rotationssymmetrische Teile für sich drehende Motoren als auch für längliche Teile für Linearmotoren eingesetzt werden. Auch die Anwendung für Generatoren ist miteingeschlossen.

Die im Folgenden genannten Ausführungsbeispiele entsprechen typischen Fertigungswegen für FeCoV-Legierungen und sollen exemplarisch aufzeigen, wie diese Wege auf die erfindungsgemäße Legierung übertragen werden können. Unter dem Begriff Blechpaket werden nicht nur Statoren oder Rotoren verstanden, sondern auch Segmente oder Einzelzähne, aus denen Statoren zusammengefügt werden.

Beschichtung

In einem Beispiel wird das erfindungsgemäße Band zunächst mit einer als DL1 bezeichneten Beschichtung aus Mg-Methylat beschichtet, die sich bei der später folgenden magnetischen Schlussglühung in Magnesiumoxid umwandelt und somit einerseits als Glühseparator dient, andererseits eine zusätzliche elektrische Isolation benachbarter Lagen mit sich bringt. In einem anderen Beispiel wird stattdessen eine als HITCOAT bezeichnete Beschichtung aus Zr-Propylat verwendet, die nach der Glühung als Zirkonoxid vorliegt.

Die genannten Beschichtungen sind nach der Glühung sehr dünn, die Schichtdicke liegt unter einem Mikrometer. Wird eine dickere Lagenisolation im Bereich von wenigen $\mu$m benötigt, so kann z.B. eine kunststoffgebundene Beschichtung auf Basis von Böhmit verwendet werden, die bei der Schlussglühung in $Al_2O_3$ umwandelt.

Glühen, Kleben, Erodieren

In einem Ausführungsbeispiel werden aus dem beschichteten Band Blechtafeln abgelängt. Diese Blechtafeln werden aufeinandergestapelt, ggf. beschwert und der erfindungsgemäßen Wärmebehandlung unterzogen. Die geglühten Bleche werden miteinander verklebt. Aus dem so hergestellten Block wird mittels Drahterodieren die Kontur des Blechpakets herausgearbeitet. Das Verfahren eignet sich vor allem für kleine Stückzahlen oder für Prototypen, bei denen das Design noch nicht endgültig festgelegt ist.

Glühen, Lasern, Fügen

In einem weiteren Ausführungsbeispiel werden aus dem Band oder aus daraus hergestellten Blechtafeln mittels Laserschneiden einzelne Blechschnitte, sogenannte Lamellen, gefertigt. Diese Einzelbleche werden anschließend aufeinandergestapelt oder auf einer oder mehreren Stangen aufgehängt und in dieser Anordnung einer erfindungsgemäßen Wärmebehandlung unterzogen. Das Fügen zum Blechpaket erfolgt anschließend z.B. durch ein Verkleben der Lamellen miteinander.

In einem weiteren Beispiel werden die geglühten Bleche über eine Laserschweißnaht miteinander verbunden. Optional kann noch eine Glühung des so hergestellten Pakets erfolgen, um die Gefügeschädigung durch das Verschweißen auszugleichen. Diese zusätzliche zweite Glühung auch als Reparaturglühung bezeichnete Wärmebehandlung muss nicht zwangsläufig bei Temperaturen oberhalb von 900°C erfolgen, sondern es reicht im Allgemeinen aus, wenn diese bei über 600°C erfolgt, so dass Versetzungen ausgeheilt werden können.

Um das bei FeCoV auftretende Längenwachstum bei der Glühung vorwegzunehmen, können die Blechtafeln zusätzlich vor dem Laserschneiden geglüht werden, was zu einer Längenänderung auf Grund der Ordnungseinstellung führt. Aus den geglühten Blechen werden anschließend Lamellen mittels Laserschneiden geformt. Die so geformten Bleche werden dann einer erneuten magnetischen Schlussglühung unterzogen. Bei dieser zweiten Glühung verändert sich die Länge des Materials nicht mehr, da das Material bereits im geordneten Zustand vorliegt. Bei diesem Verfahren reicht es aus, wenn nur eine der beiden Glühungen bei erfindungsgemäßen Temperaturen erfolgt, wobei bei beiden Glühungen die Haltetemperatur oberhalb des Ordnungs-/Unordnungsübergangs $T(\alpha'/\alpha)$ liegen sollte.

Beispielhaft kann für eine Legierung mit 49 Gew. % Co, 1,1 Gew. % V, 0,05 Gew. % Nb, Rest Fe, die Wärmebehandlung der Blechtafeln unter trockenem Wasserstoff bei nur 820°C für eine Dauer von 6 h erfolgen. Die Wärmebehandlung der geschnittenen Lamellen erfolgt dann ebenfalls unter trockenem Wasserstoff erfindungsgemäß bei 920°C für eine Dauer von 6 h. Diese Glühungen können auch in umgekehrter Reihenfolge durchgeführt werden.

Stanzen, Glühen, Laserschweißen

Für eine Serienfertigung von Blechpaketen ist das Verfahren des Stanzens von Einzelblechen geeignet. In einem Ausführungsbeispiel werden daher Lamellen gestanzt und anschließend einer erfindungsgemäßen Wärmebehandlung unterzogen, um die magnetischen Eigenschaften einzustellen. Dafür werden die Bleche z.B. in Stapeln mit mehreren Blechen aufgesetzt und ggf. mit einer Platte beschwert. Alternativ können die Teile auf einer oder mehreren Stangen aufgefädelt und hängend geglüht werden.

Die Wärmebehandlung erfolgt bei einer Temperatur von mindestens 900°C und unterhalb der Temperatur $T(\alpha/\alpha+\gamma)$. Für beste Ergebnisse sollte die Temperatur möglichst knapp unterhalb $T(\alpha/\alpha+\gamma)$ liegen.

In einem Beispiel werden die Lamellen im Anschluss an die Schlussglühung noch einer Oxidationsglühung unterzogen. Durch die bewusste Umwandlung der oberflächennahen Schicht in ein Oxid wird die elektrische Isolation benachbarter Lamellen verbessert. Die Oxidation kann z.B. unter Luft bei 350°C bis 500°C für eine Dauer von 0,5h bis 5h erfolgen.

Die geglühten und ggf. oxidierten Lamellen können nun zu einem Blechpaket gestapelt und gefügt werden. In einem Beispiel werden die Lamellen dazu mittels Laserschweißen miteinander verbunden. Dies kann z.B. durch eine oder mehrere Schweißnähte entlang der Stapelrichtung erfolgen.

Alternativ können aber auch jeweils zwei benachbarte Bleche durch ein oder mehrere Laserpunkte miteinander verbunden werden, wobei die Laserpunkte entlang der Blechhöhe zueinander versetzt sein können. Durch diese Anordnung ergeben sich für die durch die Kontaktierung entstehenden Wirbelströme längere Wege und damit ein höherer elektrischer Widerstand.

Optional kann das so erhaltene Paket noch einer weiteren Wärmebehandlung unterzogen werden, um die Schädigung durch das Schweißen aufzuheben. In diesem Fall ist es ausreichend, wenn eine der beiden Wärmebehandlungen erfindungsgemäße Glühtemperaturen aufweist, d.h. entweder die Glühung der Einzellamellen oder die Glühung des gefügten Pakets.

Beispielhaft kann für eine erfindungsgemäße Legierung mit 49 Gew. % Co, 1,0 Gew. % V, Rest Fe, die Wärmebehandlung der gestanzten Lamellen unter trockenem Wasserstoff bei einer Temperatur von 940°C und einer Dauer von 12 h erfolgen. Die Glühung des gefügten Pakets erfolgt ebenfalls unter trockenem Wasserstoff bei einer Temperatur von 820°C für eine Dauer von 4 h. Diese Glühungen können auch in umgekehrter Reihenfolge durchgeführt werden.

Stanzen, Glühen, Kleben

In einem Beispiel werden die erfindungsgemäß geglühten Lamellen durch Kleben miteinander verbunden. In diesem Fall ist keine weitere Wärmebehandlung des Pakets möglich.

Stanzen, Laserschweißen, Glühen

In einem weiteren Ausführungsbeispiel werden die Lamellen durch Stanzen hergestellt, im Anschluss gestapelt und miteinander durch Laserschweißen gefügt. In diesem Fall ist eine Schlussglühung des gefügten Pakets zwingend notwendig. Diese Wärmebehandlung sollte auch gemäß dem erfindungsgemäßen Glühverfahren erfolgen.

Stanzpaketieren, Glühen

Eine weitere, serientaugliche Möglichkeit zur Paketfertigung besteht im Stanzpaketieren, d.h. aus dem beschichteten Band werden im Werkzeug Lamellen gestanzt und dort mittels Knüpfpunkten miteinander verbunden. Das so erhaltene Paket muss einer Wärmebehandlung unterzogen werden, die erfindungsgemäß bei Temperaturen oberhalb von 900°C erfolgen soll.

**Patentansprüche**

1. Verfahren zum Herstellen eines Bandes aus einer CoFe-Legierung, umfassend:

Bereitstellen einer Schmelze bestehend im Wesentlichen aus 30 Gew. % $\leq$ Co $\leq$ 55 Gew. %, vorzugsweise 45 Gew. % $\leq$ Co $\leq$ 55 Gew. %,
0,4 Gew. % $\leq$ V $\leq$ 1,5 Gew. %, vorzugsweise 0,6 Gew. % $\leq$ V $\leq$ 1,35 Gew. %, vorzugsweise 0,8 Gew. % $\leq$ V $\leq$ 1,2 Gew. %,
0,04 Gew. % $\leq$ Nb $\leq$ 0,10 Gew. %,
0,0 Gew. % $\leq$ Ta $\leq$ 0,20 Gew. %, vorzugsweise 0,0 Gew. % $\leq$ Ta $\leq$ 0,15 Gew. %,
0,04 Gew. % $\leq$ Nb + 0,5·Ta $\leq$ 0,15 Gew. %, vorzugsweise 0,04 Gew. % $\leq$ Nb + 0,5·Ta $\leq$ 0,10 Gew. %,
max. 0,02 Gew. % C, vorzugsweise max. 0,01 Gew. %, vorzugsweise max. 0,005 Gew. %,
0,0 Gew. % $\leq$ Si $\leq$ 0,50 Gew. %, vorzugsweise 0,0 Gew. % $\leq$ Si $\leq$ 0,30 Gew. %,
0,0 Gew. % $\leq$ Al $\leq$ 0,50 Gew. %, vorzugsweise 0,0 Gew. % $\leq$ Al $\leq$ 0,30 Gew. %,
max. 0,5 Gew. % Mn, max. 0,5 Gew. % Cr, max. 0,5 Gew. % Ni, max. 0,5 Gew. % W, max. 0,5 Gew. % Mo, max. 0,5 Gew. % Zr, Rest Fe, sowie bis zu 1 Gew. % weitere Verunreinigungen besteht,
wobei die FeCoV-Legierung einen Phasenübergang von einem ferritischen $\alpha$ Phasengebiet in ein ferritisch/austenitisches $\alpha+\gamma$ Mischgebiet aufweist, der bei einer Übergangstemperatur $T(\alpha/\alpha+\gamma)$ stattfindet, wobei $T(\alpha/\alpha+\gamma) \geq 900°C$, vorzugsweise $\geq 920°C$, vorzugsweise $\geq 940°C$,
Abgießen der Schmelze unter Vakuum und anschließendes Erstarren zu einem Gussblock,
Warmwalzen des Gussblocks zu einer Bramme und anschließend zu einem Warmwalzband mit einer Dicke $d_1$, gefolgt vom Abschrecken des Bandes von einer Temperatur oberhalb der Temperatur der Ordnungseinstellung $T(\alpha'/\alpha)$ auf eine Temperatur kleiner 200 °C,
Kaltwalzen des Warmwalzbandes zu einem Band mit einer Dicke $d_2$, wobei $d_2 < d_1$,
Wärmebehandeln des Bands bei einer Temperatur $T_{max}$ und einer Haltezeit t, wobei $T_{max} \leq T(\alpha/\alpha+\gamma)$ und Tmax

EP 4 027 357 A1

> 900°C, vorzugweise $\geq$ 905°C, vorzugsweise $\geq$ 910°C, vorzugsweise $\geq$ 920°C, vorzugsweise $\geq$ 940°C.

2. Verfahren nach Anspruch 1, wobei $0{,}94 \leq$ Co/Fe $\leq 1{,}01$, vorzugsweise $0{,}97 \leq$ Co/Fe $\leq 1{,}005$ gilt.

3. Verfahren nach Anspruch 1 oder Anspruch 2, wobei die Differenz $\Delta T$ zwischen dem Phasenübergang $T(\alpha/\alpha+\gamma)$ und der Temperatur $T_{max}$ höchstens 20°C, vorzugsweise max. 10°C beträgt.

4. Verfahren nach einem der Ansprüche 1 bis 3, wobei t mindestens 0,5 h, vorzugsweise mindestens 4 h, vorzugsweise mindestens 10 h beträgt.

5. Verfahren nach einem der Ansprüche 1 bis 4, wobei die Abkühlung von $T_{max}$ bis 700°C mit einer Rate A erfolgt, die maximal bei 1000°C/h liegt,

6. Verfahren nach einem der Ansprüche 1 bis 5, wobei $d_2 \geq 0{,}35$ mm, vorzugsweise $\leq 0{,}25$ mm, vorzugsweise $\leq 0{,}15$ mm beträgt.

7. Verfahren nach einem der Ansprüche 1 bis 6, wobei $d_1 \leq 3{,}5$ mm, vorzugsweise $d_1 \leq 2{,}5$ mm, vorzugsweise $d_1 \leq 2$ mm beträgt.

8. Verfahren nach einem der Ansprüche 1 bis 7, wobei vor der Wärmebehandlung das Band mit einer Beschichtung auf Basis von Mg-Methylat, auf Basis von Zr-Propylat oder auf Basis von Böhmit beschichtet wird.

9. Verfahren nach Anspruch 8, wobei nach der Wärmebehandlung das Band eine oxidische Schicht aufweist.

10. Verfahren nach einem der Ansprüche 1 bis 9, wobei nach dem Warmwalzen das Warmwalzband von einer Temperatur $T_1$, die zwischen einem Ordnungs-/Unordnungsübergang $T(\alpha'/\alpha)$ und dem Phasenübergang $T(\alpha/\alpha+\gamma)$ liegt, abgeschreckt wird, wobei $T(\alpha'/\alpha) \leq T_1 \leq T(\alpha/\alpha+\gamma)$, vorzugsweise $T(\alpha'/\alpha) \leq T_1 \leq 850$°C.

11. Verfahren nach einem der Ansprüche 1 bis 10, wobei zum Abschrecken des Warmwalzbandes das Warmwalzband mit einer Abkühlrate von mindestens 500 K/s von $T_1$ bis 100°C, vorzugsweise mit mindestens 1000 K/s, vorzugsweise 2000 K/s abgeschreckt wird.

12. Verfahren nach Anspruch 11, wobei das Warmwalzband in einem Eis-Salzwasserbad mit einer Abkühlrate von mindestens 500 K/s von $T_1$ bis 100°C, vorzugsweise mit mindestens 1000 K/s, vorzugsweise 2000 K/s abgeschreckt wird.

13. Verfahren nach einem der Ansprüche 1 bis 12, wobei vor dem Kaltwalzen das Band auf eine Temperatur zwischen 20°C und 300°C, vorzugsweise zwischen 30°C und 300°C, vorzugsweise zwischen 50°C und 200°Cangewärmt wird.

14. Verfahren nach Anspruch 13, wobei mehrere Kaltwalzschritte durchgeführt werden, und das Band zwischen Kaltwalzschritten auf eine Temperatur zwischen 20°C und 300°C, vorzugsweise zwischen 30°C und 300°C, vorzugsweise zwischen 50°C und 200°C angewärmt wird.

15. Verfahren nach einem der Ansprüche 1 bis 14, wobei das Band nach der Wärmebehandlung

eine Polarisation J(16 kA/m) $\geq 2{,}30$ T, vorzugsweise $\geq 2{,}32$ T, vorzugsweise $\geq 2{,}34$ T, und/oder
eine Maximalpermeabilität $\mu_{max} > 25.000$, vorzugsweise $\geq 30.000$, vorzugsweise $\geq 35.000$, und/oder
eine Koerzitivfeldstärke Hc $\leq 30$ A/m, vorzugsweise $\leq 25$ A/m, vorzugsweise $\leq 20$ A/m und/oder
einen elektrischen Widerstand von mindestens 0,15 $\mu\Omega$m aufweist.

Fig. 1

Fig. 2

Fig. 3

Fig. 4

Fig. 5

Fig 6

B3

Fig 7

B8

Fig 8

**Europäisches Patentamt**
**European Patent Office**
**Office européen des brevets**

## EUROPÄISCHER RECHERCHENBERICHT

Nummer der Anmeldung

EP 21 21 5546

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2018/091694 A1 (VACUUMSCHMELZE GMBH & CO KG [DE]) 24. Mai 2018 (2018-05-24) * Seite 10, Absatz 1; Ansprüche 1,11-13; Abbildung 3 * * Seite 3, Absatz 3 * * Seite 13, Absatz 2 * * Seite 7, Absatz 1 * ----- | 1-15 | INV. H01F1/18 C21D1/26 C21D8/12 C22C19/07 C22C38/12 |
| A | DE 10 2019 107422 A1 (VACUUMSCHMELZE GMBH & CO KG [DE]) 24. September 2020 (2020-09-24) * Absatz [0034]; Ansprüche 1,3,4 * ----- | 1-15 | |
| A | DE 10 2012 105605 A1 (VACUUMSCHMELZE GMBH & CO KG [DE]) 3. Januar 2013 (2013-01-03) * Absätze [0063] - [0065] * ----- | 1-15 | |
| A | WO 2020/130643 A1 (POSCO CO LTD) 25. Juni 2020 (2020-06-25) * Absätze [0055], [0056] * & US 2022/074011 A1 (HAN MIN SOO [KR] ET AL) 10. März 2022 (2022-03-10) ----- | 1-15 | RECHERCHIERTE SACHGEBIETE (IPC) H01F C21D C22C |

Der vorliegende Recherchenbericht wurde für alle Patentansprüche erstellt

| Recherchenort | Abschlußdatum der Recherche | Prüfer |
|---|---|---|
| München | 24. Mai 2022 | Primus, Jean-Louis |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

..................................................................

& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 21 21 5546

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

24-05-2022

| Im Recherchenbericht angeführtes Patentdokument | Datum der Veröffentlichung | Mitglied(er) der Patentfamilie | Datum der Veröffentlichung |
|---|---|---|---|
| WO 2018091694 A1 | 24-05-2018 | DE 102016222805 A1 | 24-05-2018 |
| | | EP 3541969 A1 | 25-09-2019 |
| | | US 2019360065 A1 | 28-11-2019 |
| | | WO 2018091694 A1 | 24-05-2018 |
| DE 102019107422 A1 | 24-09-2020 | DE 102019107422 A1 | 24-09-2020 |
| | | EP 3712283 A1 | 23-09-2020 |
| | | US 2020299820 A1 | 24-09-2020 |
| | | US 2021388476 A1 | 16-12-2021 |
| DE 102012105605 A1 | 03-01-2013 | DE 102012105605 A1 | 03-01-2013 |
| | | GB 2492406 A | 02-01-2013 |
| WO 2020130643 A1 | 25-06-2020 | CN 113227411 A | 06-08-2021 |
| | | JP 2022514938 A | 16-02-2022 |
| | | KR 20200076516 A | 29-06-2020 |
| | | US 2022074011 A1 | 10-03-2022 |
| | | WO 2020130643 A1 | 25-06-2020 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2495465 B